(19) **Europäisches Patentamt European Patent Office Office européen des brevets**

(11) **EP 4 672 494 A1**

(12) **EUROPEAN PATENT APPLICATION**

(43) Date of publication:
**31.12.2025 Bulletin 2026/01**

(21) Application number: **25169122.6**

(22) Date of filing: **08.04.2025**

(51) International Patent Classification (IPC):
*H01P 5/04* (2006.01)    *H01P 5/18* (2006.01)
*H01P 3/16* (2006.01)    *H01Q 1/22* (2006.01)

(52) Cooperative Patent Classification (CPC):
**H01P 5/18; H01P 5/04;** H01P 3/16; H01Q 1/2283

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **25.06.2024 US 202418752911**

(71) Applicant: **INTEL Corporation Santa Clara, CA 95054 (US)**

(72) Inventors:
• **YANG, Tae Young Portland, 97229 (US)**
• **SHIN, Woorim Portland, 97229 (US)**
• **ZHOU, Zhen Chandler, 85248 (US)**
• **HORINE, Bryce D. Portland, 97229 (US)**

(74) Representative: **Viering, Jentschura & Partner mbB Patent- und Rechtsanwälte Am Brauhaus 8 01099 Dresden (DE)**

(54) **RECONFIGURABLE CHANNELS FOR MULTIDROP, MULTIMODE, AND DUAL POLARIZATION COMMUNICATION BETWEEN ANY OF CHIPLETS, DIES, PACKAGES, MODULES, AND PRINTED CIRCUIT BOARDS**

(57)    An integrated chiplet system includes a printed circuit board (PCB), including a first antenna; a first chiplet, electrically conductively coupled to a second antenna; a second chiplet, electrically conductively coupled to a third antenna; and a waveguide, configured to direct a signal from the first antenna to the second antenna or the third antenna.

**FIG. 47**

**Description**

**Technical Field**

Various aspects of this disclosure generally relate to the use of a reconfigurable coupler for signal transfer via waveguides in a heterogeneous chiplet environment.

**Background**

In accordance with Moore's law, transistor feature sizes have been shrinking over the last several decades. Meanwhile, there have been great advances in interconnect and packaging technologies. These advances have given rise to heterogeneous integration, which integrates different 'chiplets' at the package level, thereby permitting the best available technology node for each chiplet to be used, rather than using a lowest common technology node for all chiplets. Such heterogeneous integration techniques may use, for example, any combination of central processing units (CPUs), neural processing units (NPUs), graphics processing units (GPUs), field-programmable gate arrays (FPGAs), sensors, memories, or other types of chiplets together in the same environment (e.g., in the same package, in the same multipackage-array, etc.)

Such heterogeneous integration architectures, however, require high-throughput data exchanges among the various components. One known solution uses wireline communication over a point-to-point wired interconnect, which permits high data throughput using multiple parallel interconnects. However, such wireline interconnects only support point-to-point communication links, and data transfer is often limited to adjacent chiplets. Moreover, both the transceiver architecture's complexity and communication system's power consumption increase significantly as data rates and communication distances increase.

As a result, millimeter-wave (mm-Wave) and sub-THz wireless technologies have been considered as a complement to wireline communication over a point-to-point wired interconnect. Such techniques make use of wireless technology, which can support flexible communication topologies through a shared medium (i.e. free-space). The use of mm-Wave/sub-THz frequency bands provides wide available bandwidth in the frequency spectrum to support high data rates. The phased array transceiver architecture is often proposed in mm-Wave/sub-THz bands, as it supports beamforming and beam-steering capabilities to increase communication distance and to enable spatial-multiplexing. However, the phased array transceiver comes with its own challenges in (1) designing electrically-small phased array, (2) achieving low power consumption with multiple transceiver elements, and (3) addressing interference and coupling issues arising from the uncontrolled nature of the communication channel.

In light of this, it is desired to utilize mm-Wave/sub-THz frequency bands for communication in a heterogeneous chiplet environment without the need for phase array technology.

**Brief Description of the Drawings**

In the drawings, like reference characters generally refer to the same parts throughout the different views. The drawings are not necessarily to scale, emphasis instead generally being placed upon illustrating the exemplary principles of the disclosure. In the following description, various exemplary embodiments of the disclosure are described with reference to the following drawings, in which:

FIG. 1 depicts a heterogeneous collection of chiplets integrated as one device;
FIG. 2 depicts a software defined reconfigurable channel in the context of a multichip package;
FIG. 3 depicts a reconfigurable coupler;
FIG. 4 depicts a coupler structure using two cascaded couplers and two identical-type reconfigurable phase shifters;
FIG. 5 depicts a simulation of the coupler of FIG. 4 with respect to $S_{21}$;
FIG. 6 depicts a simulation of the coupler of FIG. 4 with respect to a narrowband coupling factor C and $S_{31}$ for phase differences between phase shifters;
FIG. 7 depicts a wideband reconfigurable coupler architecture using true time delays (TTDs);
FIG. 8 depicts a simulation result for a D band (110-170 GHz) based on the reconfigurable coupler of FIG. 7 through $S_{21}$;
FIG. 9 depicts simulation results for the D band using a wideband coupling factor C and $S_{31}$ for various time delay differences between TDDs;
FIG. 10 depicts a simplified top side view of a transition between the proposed contactless coupler and a dielectric waveguide;
FIGs. 11A and 11B depict an exemplary contactless coupler implemented in a non-monolithic die;
FIG. 12 depicts an alternative contactless coupler;

FIG. 13 depicts a simulation result of the exemplary vertically polarized contactless coupler of FIG. 12 for a 10 mm dielectric glass waveguide channel;

FIG. 14 depicts an exemplary horizontally polarized contactless coupler chiplet;

FIG. 15 depicts simulation results of the exemplary horizontally polarized contactless coupler of FIG. 14 for a 10 mm dielectric glass waveguide channel;

FIG. 16 depicts vertically and horizontally polarized bi-directional coupler designs using contactless couplers and glass dielectric waveguide channels;

FIG. 17. depicts simulated electric field distributions at each of 140 and 200 GHz for vertical and horizontal polarization couplers;

FIG. 18 shows simulated coupling factor versus frequency between vertically and vertically polarized bidirectional couplers;

FIG. 19 depicts simulated electric field distribution at 140 GHz for vertically polarized bidirectional couplers in a ring network;

FIG. 20 depicts simulated electric field distribution at 140 GHz for vertically polarized bidirectional couplers in a terminated network;

FIG. 21 depicts the reconfigurable coupler in a vertical-to-vertical polarization configuration;

FIG. 22 depicts the reconfigurable coupler in a vertical-to-horizontal polarization configuration;

FIG. 23 depicts the reconfigurable coupler in a horizontal-to-horizontal configuration;

FIG. 24 depicts the reconfigurable coupler as an equivalent block diagram symbol;

FIG. 25 depicts an example dielectric (or magneto-dielectric) channel varying width and/or height of the channel structures to support multimode excitations and dual polarization;

FIG. 26 depicts an exemplary design block diagram;

FIG. 27 depicts a signal flow graph;

FIG. 28 depicts simulation results representing a comparison of Tx-Rx isolation results for the example block diagrams in FIG. 26;

FIG. 29 depicts the integration of dielectric (or magneto-dielectric) channels and a single chiplet equipped with dual-polarized couplers, reconfigurable couplers, and impedance loads;

FIG. 30 depicts QPSK in a 16-QAM signal constellation;

FIG. 31 depicts an example in which both quadrature phase shift keying (QPSK) and 16-QAM signals can only be decoded at Rx_B;

FIG. 32 depict Rx_B and Rx_C with a 10-dB coupling coefficient that allows the device to decode QPSK signals only;

FIG. 33 depicts an example in which both quadrature phase shift keying (QPSK) and 16-QAM signals can only be decoded at Rx_C;

FIG. 34 depicts two exemplary forms of network topologies;

FIG. 35 depicts a reconfigurable unilateral multidrop network;

FIG. 36 depicts a multi-directional topology that is augmented into multi-directional network;

FIG. 37 shows an example scenario of chip-to-chip communication in die/package/PCB level;

FIG. 38 depicts a directional coupler;

FIG. 39 depicts a signal flow when the power is driven from port 2;

FIG. 40 shows signal flow when the power is driven from port 3;

FIG. 41 depicts an example of a simple communication link formed by two transceivers, and two directional couplers, and a transmission line with proper terminations;

FIG. 42 depicts the communication channel configuration of FIG. 41 but with 0-dB couplers;

FIG. 43 depicts a cascaded configuration of directional couplers that includes one transmitter and two receivers; and

FIG. 44 depicts an example case of a 1:2 communication link;

FIG. 45 depicts an example case of two 1:1 communication links;

FIG. 46 depicts an example case of circular channel formation; and

FIG. 47 depicts an integrated chiplet system.

## Description

The following detailed description refers to the accompanying drawings that show, by way of illustration, exemplary details and embodiments in which aspects of the present disclosure may be practiced.

The word "exemplary" is used herein to mean "serving as an example, instance, or illustration". Any embodiment or design described herein as "exemplary" is not necessarily to be construed as preferred or advantageous over other embodiments or designs.

Throughout the drawings, it should be noted that like reference numbers are used to depict the same or similar elements, features, and structures, unless otherwise noted.

The phrase "at least one" and "one or more" may be understood to include a numerical quantity greater than or equal to one (e.g., one, two, three, four, [...], etc.). The phrase "at least one of" with regard to a group of elements may be used herein to mean at least one element from the group consisting of the elements. For example, the phrase "at least one of" with regard to a group of elements may be used herein to mean a selection of: one of the listed elements, a plurality of one of the listed elements, a plurality of individual listed elements, or a plurality of a multiple of individual listed elements.

The words "plural" and "multiple" in the description and in the claims expressly refer to a quantity greater than one. Accordingly, any phrases explicitly invoking the aforementioned words (e.g., "plural [elements]", "multiple [elements]") referring to a quantity of elements expressly refers to more than one of the said elements. For instance, the phrase "a plurality" may be understood to include a numerical quantity greater than or equal to two (e.g., two, three, four, five, [...], etc.).

The phrases "group (of)", "set (of)", "collection (of)", "series (of)", "sequence (of)", "grouping (of)", etc., in the description and in the claims, if any, refer to a quantity equal to or greater than one, i.e., one or more. The terms "proper subset", "reduced subset", and "lesser subset" refer to a subset of a set that is not equal to the set, illustratively, referring to a subset of a set that contains less elements than the set.

The term "data" as used herein may be understood to include information in any suitable analog or digital form, e.g., provided as a file, a portion of a file, a set of files, a signal or stream, a portion of a signal or stream, a set of signals or streams, and the like. Further, the term "data" may also be used to mean a reference to information, e.g., in form of a pointer. The term "data", however, is not limited to the aforementioned examples and may take various forms and represent any information as understood in the art.

The terms "processor" or "controller" as, for example, used herein may be understood as any kind of technological entity that allows handling of data. The data may be handled according to one or more specific functions executed by the processor or controller. Further, a processor or controller as used herein may be understood as any kind of circuit, e.g., any kind of analog or digital circuit. A processor or a controller may thus be or include an analog circuit, digital circuit, mixed-signal circuit, logic circuit, processor, microprocessor, Central Processing Unit (CPU), Neural Processing Unit (NPU), Graphics Processing Unit (GPU), Digital Signal Processor (DSP), Field Programmable Gate Array (FPGA), integrated circuit, Application Specific Integrated Circuit (ASIC), etc., or any combination thereof. Any other kind of implementation of the respective functions, which will be described below in further detail, may also be understood as a processor, controller, or logic circuit. It is understood that any two (or more) of the processors, controllers, or logic circuits detailed herein may be realized as a single entity with equivalent functionality or the like, and conversely that any single processor, controller, or logic circuit detailed herein may be realized as two (or more) separate entities with equivalent functionality or the like.

As used herein, "memory" is understood as a computer-readable medium (e.g., a non-transitory computer-readable medium) in which data or information can be stored for retrieval. References to "memory" included herein may thus be understood as referring to volatile or non-volatile memory, including random access memory (RAM), read-only memory (ROM), flash memory, solid-state storage, magnetic tape, hard disk drive, optical drive, 3D XPointTM, among others, or any combination thereof. Registers, shift registers, processor registers, data buffers, among others, are also embraced herein by the term memory. The term "software" refers to any type of executable instruction, including firmware.

Unless explicitly specified, the term "transmit" encompasses both direct (point-to-point) and indirect transmission (via one or more intermediary points). Similarly, the term "receive" encompasses both direct and indirect reception. Furthermore, the terms "transmit," "receive," "communicate," and other similar terms encompass both physical transmission (e.g., the transmission of radio signals) and logical transmission (e.g., the transmission of digital data over a logical software-level connection). For example, a processor or controller may transmit or receive data over a software-level connection with another processor or controller in the form of radio signals, where the physical transmission and reception is handled by radio-layer components such as radiofrequency (RF) transceivers and antennas, and the logical transmission and reception over the software-level connection is performed by the processors or controllers. The term "communicate" encompasses one or both of transmitting and receiving, i.e., unidirectional or bidirectional communication in one or both of the incoming and outgoing directions. The term "calculate" encompasses both 'direct' calculations via a mathematical expression/formula/relationship and 'indirect' calculations via lookup or hash tables and other array indexing or searching operations.

A highly reconfigurable channel (as sometimes called "software-defined channel") may use reconfigurable couplers in a controlled medium, which allows flexible communication links and mimics beamforming/beam-steering functionalities without using phased array technology. Both broadcasting and multipoint-to-multipoint communications between chip(let)s, dies, packages, and PCBs are supported through software-defined reconfigurable channel, without using conventional phased array approach.

As described above, the conventional use of wireline communication to transfer data from one chip to another chip provides only point-to-point links without any flexibility in link configuration; requires a separate communication link for chiplets in non-adjacent locations; and requires lead-time to optimize a hard-wired communication topology between chiplets for a targeted customer and application scenarios. Phased array (e.g. beamforming) techniques have been considered for heterogeneous multi-chip packages, but these require multiple antenna arrays, which themselves present challenges in terms of size and of power consumption. These disadvantages may be largely overcome by the software defined reconfigurable waveguide arrangements disclosed herein.

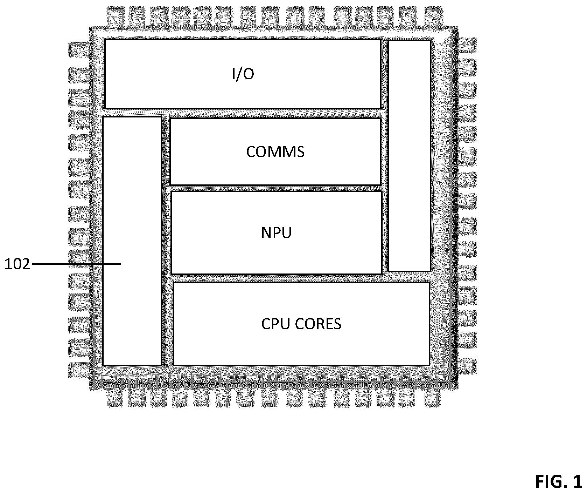

For context, FIG. 1 depicts a heterogeneous collection of chiplets integrated as one device. In such configurations, multiple chiplets are combined together, thereby necessitating communication between the chiplets. Each chiplet may be of a different technology node, or at least there may potentially be no consistent technology node among the chiplets, further complicating the communication among devices. Such a heterogeneously integrated system can benefit from flexible communications links, such as the software-defined channel disclosed herein. The software-defined channel may include any guided-wave structure (such as a shared structure or a dedicated structure). It may be configured to operate in radiofrequency (RF), microwave, mm-wave, sub-THz, or optical frequencies. It may be located in an interposer, in or on the package, in or on the heatsink, or otherwise. The reconfigurable coupler may optionally be a four-port directional coupler and may exhibit a reconfigurable coupling coefficient.

The data-communication bandwidth between chiplets is fixed and thus cannot be reconfigured when an application scenario changes (e.g. the GP-GPU 102 would be more efficient for single-precision computation while the CPU would be more efficient for double-precision/floating-point computation). The field programmable gate arrays (FPGAs) can be programmed to at least somewhat manage both fixed-point and floating-point computations. Neural processing units (NPU) specifically accelerate machine learning algorithms; however, the best computational efficiency and tera-operations per seconds (TOPS) can be achieved from a reconfigurable communication bandwidth between the GP-GPU/CPU/NPU/FPGA chiplets for dynamic commutation load changes. This is desirable for future artificial-intelligence-related application computations. In other words, heterogeneous chiplet integration demands dynamic computational load/communication bandwidth between chiplets.

The principles and methods disclosed herein include, at least, a reconfigurable channel architecture with broadband reconfigurable couplers; and contactless couplers for a dielectric waveguide channel. Of note, it is possible to integrate the coupler into a chip. The reconfigurable channel architecture may support not only multimode and multidrop communication, but also horizontally polarized modes and vertically polarized modes. The reconfigurable channel architecture may include communication range controls through channel structure shaping (i.e. waveguide propagation mode filtering) and/or hierarchical modulation. It may enable duplex communication with an isolation enhanced coupler and support network segmentation. It may be configurable in various network topologies

A versatile reconfigurable channel may be formed with a dedicated and shared guided-wave medium and reconfigurable directional couplers. Each chip(let)/die/package/PCB may have access to the channel through transceivers attached to the directional couplers. The couplers have reconfigurable coupling coefficients in such a way that the amount of signal energy flow can be arbitrarily controlled.

The channels using the coupling techniques described herein may have the following properties. They may be capable of multidrop, multimode, multipoint-to-multipoint communication. They may be free, or largely free, from spurious environmental interference. They may support flexible configuration of communication links. They may replace the functionality of phased-array antennas (PAAs). Signal to noise (SNR) control with beamforming capability of PAAs may be replaced by reconfigurable couplers with assignment of non-identical coupling coefficients. Flexible link with beam-steering of PAAs may be replaced by reconfigurable coupling coefficient feature. Finally, spatial multiplexing with a multi-beam configuration of PAAs may replace channel segmentation with 0-dB coupling, or approximate 0-dB coupling.

In some optional configurations, the channels using the coupling techniques described herein may support duplex communications, support simultaneous control and data communication through hierarchical modulation, and improve testability of heterogeneously integrated systems. They may support communication in a complex topology with a high degree of reconfigurability. They may support chiplet-chiplet, die-die, package-package, and PCB-PCB communications. Alternatively or additionally, they may allow communications between any of the chiplet, dies, package, and PCB. They may support both vertically and horizontally polarized reconfigurable couplers for dielectric (or magneto-dielectric) waveguide channels. The techniques disclosed herein allow for communication between chiplets, dies, packages, and a PCB, including non-adjacent pairs, with improved energy-efficiency and cost-effectiveness compared to conventional solutions. Such communication removes significant constraints in heterogeneous chiplet integration floor planning and reduces overall package cost.

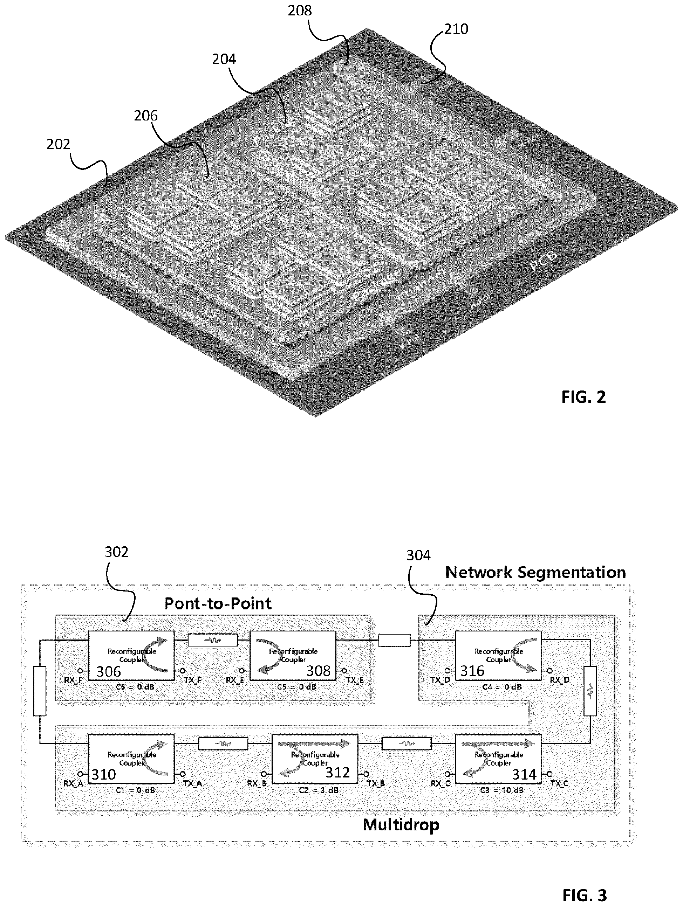

FIG. 2 depicts the software defined reconfigurable channel in the context of a multichip package, as described herein. In this figure, a PCB 202 supports a plurality of packages (one package depicted herein as 204), which house a plurality of chiplets (one chiplet depicted herein as 206). The PCB 202, the packages, 204, and the chiplets 206, are connected via a reconfigurable channel 208. This connection is made possible through the use of various antennas (an exemplary antenna is depicted herein as 210). The antennas may be located on the PCB 202, on the packages 204, or coupled directly to the chiplets 206. As shown, the antennas may have a vertical polarization or a horizontal polarization. This reconfigurable channel may enable communications between chiplet and chiplet, die and die, package and package, and PCB and PCB, but also among any combination of chiplets, dies, packages, and PCBs. This software defined reconfigurable channel further supports multidrop, multimode, and dual polarization features.

The reconfigurable channel may be used with form of communication medium, and it may support guided waves. The reconfigurable channel may include one or more waveguides, such as metallic, dielectric, and/or magneto-dielectric waveguides; transmission lines (e.g., microstrips, striplines, and/or coplanar waveguides). It may be shared among multiple transceivers, thereby allowing transmissions from or to a plurality of sources. The reconfigurable channel may be isolated, or dedicated to purposes of communication. It may be configured to connect with the various transceivers via coupling structures, which themselves may be reconfigurable. It may include combinations of couplers and switches, so as to route transmissions to desired destinations. The reconfigurable channel may support variable configurations in the amount of coupling used, so as to determine a magnitude of a signal that is directed to one or more locations. It may support 0-dB coupling, although it is recognized that 0-dB coupling, as used herein, may refer to an ideal practice, whereas real implementations of 0-dB coupling may vary slightly from this ideal. The coupling structure may be directional or bidirectional and may be able to distinguish between forward-waves and reverse-waves. The communication channel (also referred to herein as the "software-defined channel") may provide a reconfigurable channel with flexible resource allocation and channel sectorization between chiplets, dies, packages, or PCBs.

Key to the communication channel is the reconfigurable coupler, an exemplary model of which is depicted in FIG. 3. As shown in this figure, the reconfigurable coupler may provide point-to-point communication 302, and may also be used for network segmentation and multidrop communication 304. In this figure, and relative to the point-to-point communication 302, the signal received by coupler 306 is transmitted to coupler 308. With respect to the network segmentation and multidrop communication 304, a signal received at coupler 310 is transmitted to coupler 312, where it is output at RX_B. The signal is further transmitted from coupler 312 to coupler 314, where it is output as RX_C. The signal is then further transmitted from coupler 314 to coupler 316, where it is output as RX_D. This image stands at least for the proposition that the reconfigurable couplers as disclosed herein may be configured so as to transmit some or all of the signal to one or more desirable couplers. In some circumstances, the couplers may be configured to receive signals for (e.g. be attached to) any, or any combination of, the PCB, the package, or one or more chiplets. Here, it is noted that the reconfigurable coupler, as will be described in greater detail below, can be implemented in essentially any combination of point-to-point, multipoint, or network segmentation configuration, as selected for the given implementation.

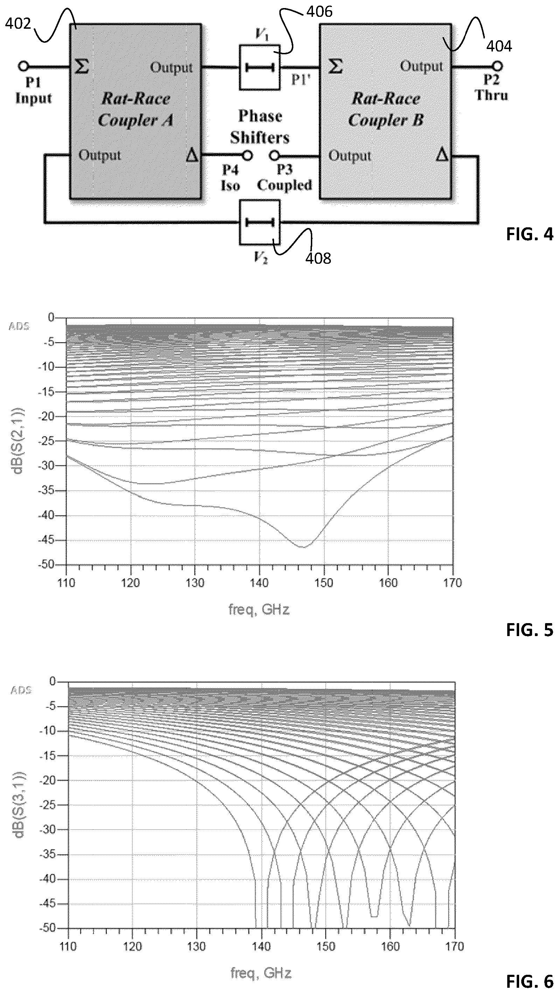

Although reconfigurable couplers are known, conventional reconfigurable couples suffer from a limited tunable range of coupling factor C due to the required wide coupling coefficient k reconfigurability (k = ~0.9 for C = 1 dB and k = 0.1 for C = 20 dB) between coupled inductors (or transmission lines). To overcome the challenges of a conventional reconfigurable coupler, a new coupler structure using two cascaded couplers and two identical-type reconfigurable phase shifters has been proposed in literature, as depicted in FIG. 4. In this figure, a first coupler 402 and a second coupler 404 are cascaded and coupled to reconfigurable phase shifter one 406 and an identical reconfigurable phase shifter two 408. The reconfigurability may be achieved by a phase difference between two phase shifters. In addition, any type of coupler can be used if a pair of couplers is identical. The coupler supports a wide reconfigurable range of coupling factor C, although it may suffer from narrow bandwidth. This can be seen, for example, in FIG. 5, which depicts a simulation of the coupler of FIG. 4 with respect to $S_{21}$, and FIG. 6, which depicts a simulation of the coupler of FIG. 4 with respect to a narrowband coupling factor C and $S_{31}$ for phase differences between phase shifters.

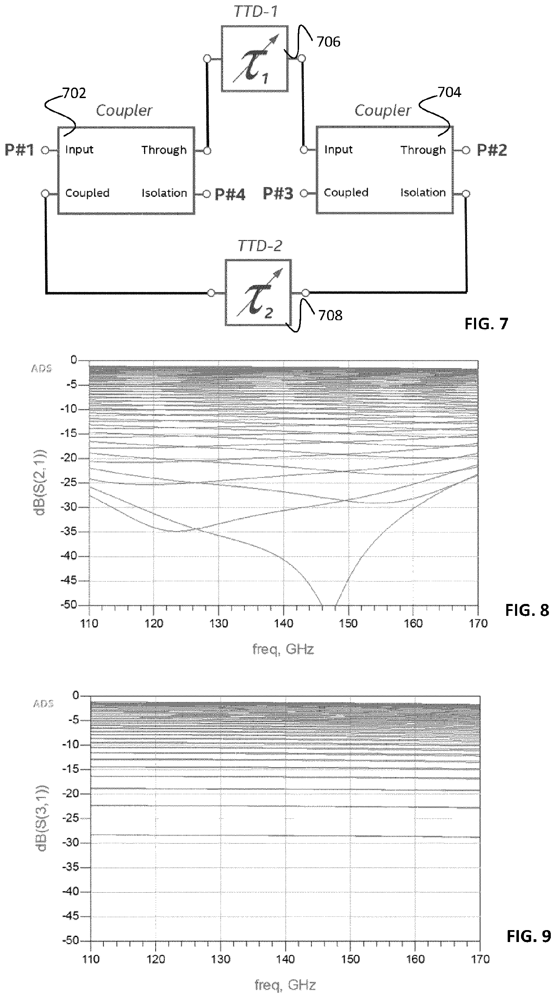

FIG. 7 depicts a disclosed wideband reconfigurable coupler architecture using reconfigurable true time delays (TTDs), which permits improved broadband coupling. As can be seen, a first coupler 702 is coupled to a second coupler 704 via a first TTD 706 and a second TTD 708. FIG. 8 depicts a simulation result for a D band (110-170 GHz) based on the reconfigurable coupler of FIG. 7 through $S_{21}$. The constant time difference between TTDs offers wide operational bandwidth as well as tunable range of coupling factor C. FIG. 9 depicts simulation results for the D band using a wideband coupling factor C and $S_{31}$ for various time delay differences between TTDs.

Regarding the use of supportive dielectric (or magneto-dielectric) waveguides, dielectric waveguide channels are known for at least sub-THz / THz interconnect applications. These may mimic optical fibers and take advantage of some of the proven optics-based benefits at relatively lower frequencies (subTHz/THz) with lower cost and reduced sensitivity. One obvious trade-off, however, is the reduced data throughputs and limited communication range that they offer. However, unlike reconfigurable couplers that are based on passive/active circuits, and unlike channel using transmission lines (microstrip, stripline, coplanar waveguide (CPW)), coupling to dielectric waveguides (or magneto-dielectric waveguides, where both relative permittivity and permeability are greater than 1) can be challenging. Such known coupler structures are typically bulky and/or only applicable for vertically polarized waveguide modes. In addition, these couplers are difficult to integrate in a chip. In light of this, it is desirable to identify a new coupler that may represent an improvement over known coupler structures.

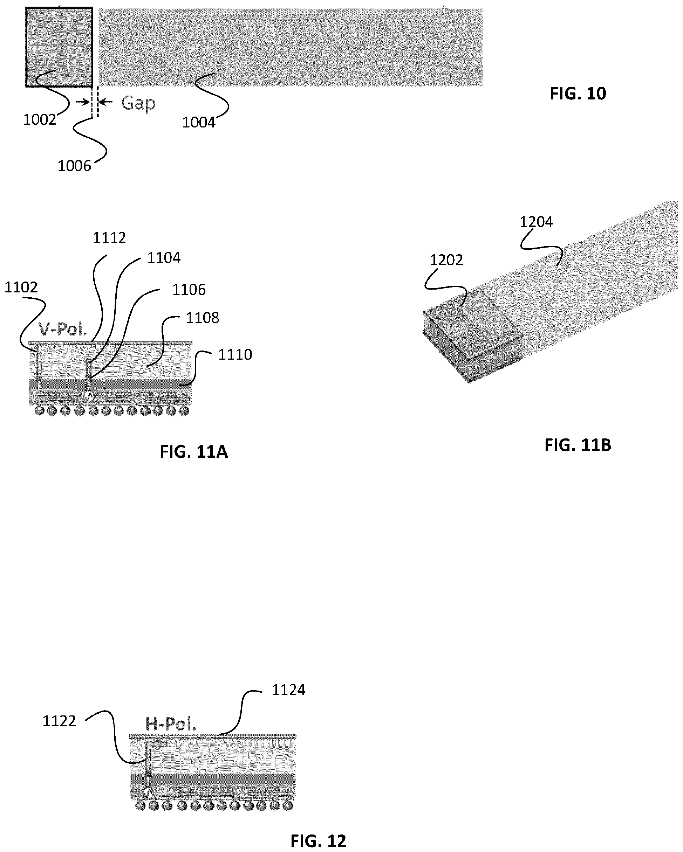

FIG. 10 depicts a simplified top side view of a transition between the proposed contactless coupler and a dielectric waveguide. In this figure, a vertically polarized or horizontally polarized contactless coupler chiplet 1002 is depicted as being next to/coupled to a dielectric waveguide 1004, with a gap 1006 between them. Unlike conventional coupler designs, this contactless coupler chiplet can be integrated in a non-monolithic die. That is, the coupler can be integrated both during and after the die-manufacturing process. The gap 1006 also permits some ability to replace parts after manufacturing.

FIG. 11A depicts exemplary contactless coupler implemented in a non-monolithic die, wherein the contactless coupler is vertically polarized. FIG. 11B depicts an alternative view of the contactless coupler of FIG. 11A. In FIG. 11A, a reflector 1102 (which may be, for example, a through-hole via or any other structure), and an antenna 1104 (which may be a blind via or any other structure), are vertically polarized. Antennas may be bonded to the substrate using hybrid bonding, direct bonding, or any other bonding method as depicted in 1106. Antennas may be housed at least partially within a substrate 1108, such as a silicon substrate, a glass substrate or an organic substrate. The substrate of 1108 may be placed upon a silicon substrate 1110. Element 1112 is a top GND layer, which corresponds to element 1202 in FIG. 11B. Element 1102 is a reflector through-hole via which renders the antenna unidirectional. Element 1104 is an antenna which is coupled to the FR source through a bonding 1104.

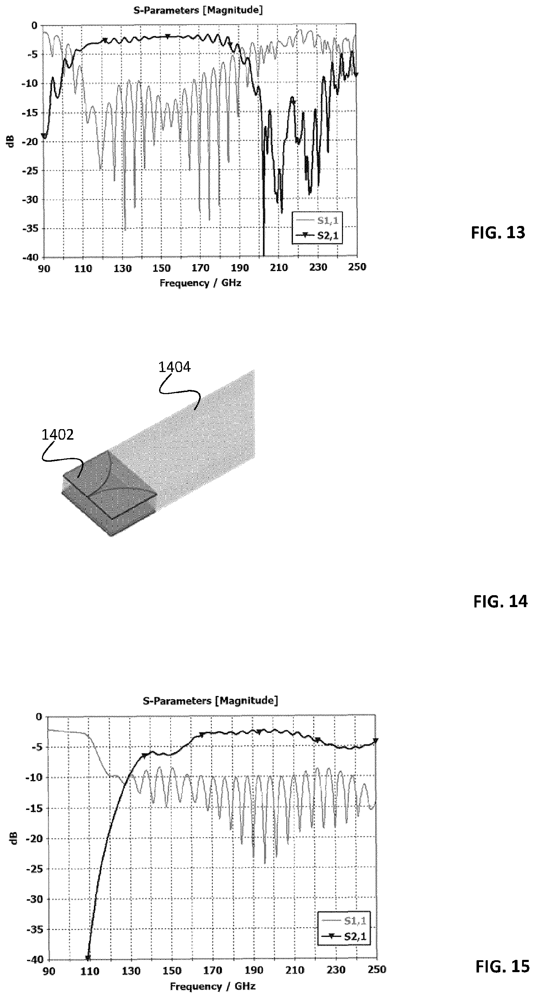

The antenna 1124 may be a tapered slot structure with horizontally polarization and unidirectional coupling property. 1124 is a tapered slot antenna that exhibits a unidirectional radiation property (e.g., it does not need a reflector). The bent feed 1122 is coupled to that RF source through a bonding. The feed 1122 is capacitively coupled to the tapered slot antenna 1124. For the vertically polarized contactless coupler, the excitation source of the main driven via (for example, a blind glass via, a silicon via, etc.) may be located between the middle and bottom layers of the coupler chiplet for higher coupling efficiency. Alternatively, a tapered slot structure for a horizontally polarized contactless coupler may be located between the middle and surface layers of the coupler chiplet for higher coupling efficiency. Of relevance here is that the excited horizontal-polarization mode is a higher order than the vertical-polarization mode. These two modes are orthogonal to each other. For context, the tapered slot antenna 1124 corresponds to that of FIG. 14 1403.

FIG. 12 depicts an exemplary vertically polarized contactless coupler according to an aspect of the disclosure. In this figure, the vertically polarized contactless coupler chiplet 1202 is placed next to (and coupled to) the dielectric waveguide 1204. This vertically polarized contactless coupler is shown with an exemplary 10-mm dielectric (in this case, glass, although other media would be possible) waveguide channel. The panel-level glass design is depicted with an exemplary 250-$\mu$m thick core thickness and top- and-bottom redistribution layers (RDLs) are used for the coupler design. FIG. 13 depicts a simulation result of the exemplary vertically polarized contactless coupler of FIG. 12 for a 10 mm dielectric glass waveguide channel, wherein reflection and transmission coefficients are depicted relative to frequency.

FIG. 14 depicts an exemplary horizontally polarized contactless coupler chiplet according to another aspect of the disclosure. In this figure, the horizontally polarized contactless coupler chiplet 1402 is next to (and coupled to) the dielectric waveguide 1404. FIG. 15 depicts simulation results of the exemplary horizontally polarized contactless coupler of FIG. 14, for a 10 mm dielectric glass waveguide channel, wherein reflection and transmission coefficients are depicted relative to frequency.

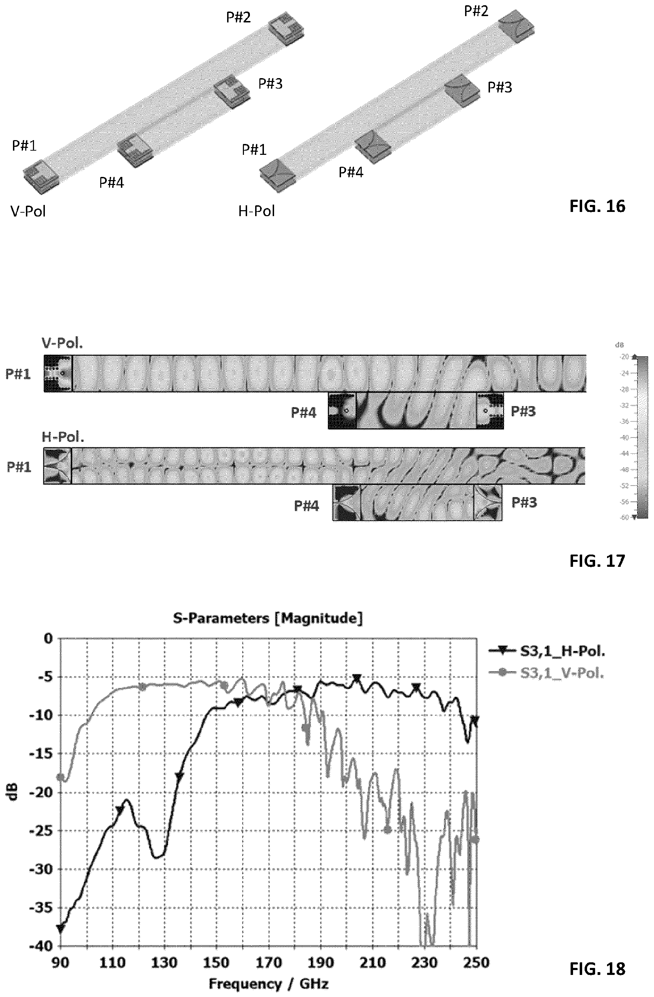

FIG. 16 depicts vertically and horizontally polarized bi-directional coupler designs using contactless couplers and glass dielectric waveguide channels. Simulated electric field distributions are depicted in FIG. 17 at 140 and 200 GHz for vertical and horizontal polarization couplers, respectively. FIG. 18 shows simulated coupling factor versus frequency between vertically and vertically polarized bidirectional couplers.

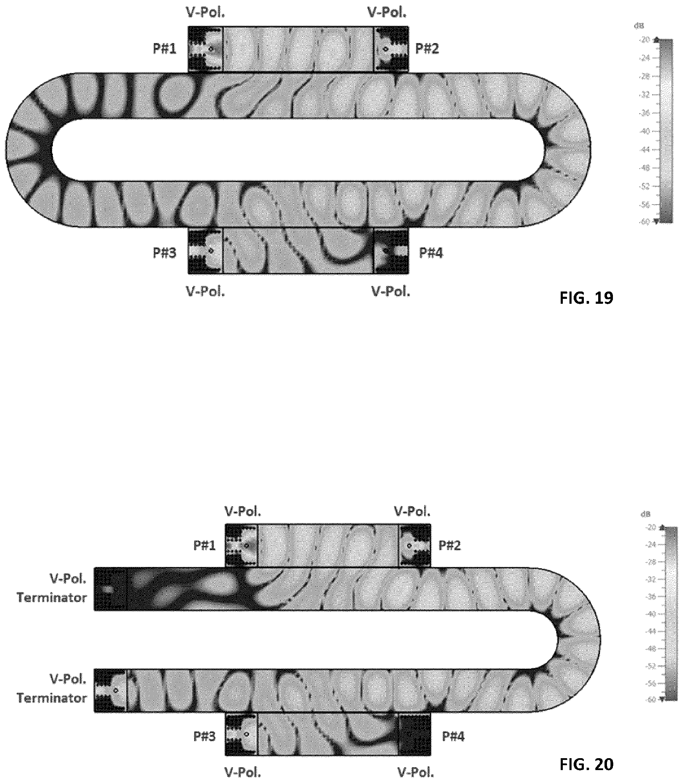

FIG. 19 depicts simulated electric field distribution at 140 GHz for vertically polarized bidirectional couplers in a ring network. FIG. 20 depicts a simulated electric field distribution at 140 GHz for vertically polarized bidirectional couplers in a terminated network. The vertically polarized contactless coupler terminated with reference impedance is used as a network termination to avoid reflections. These two examples suggest that the proposed contactless couplers can support various network topologies.

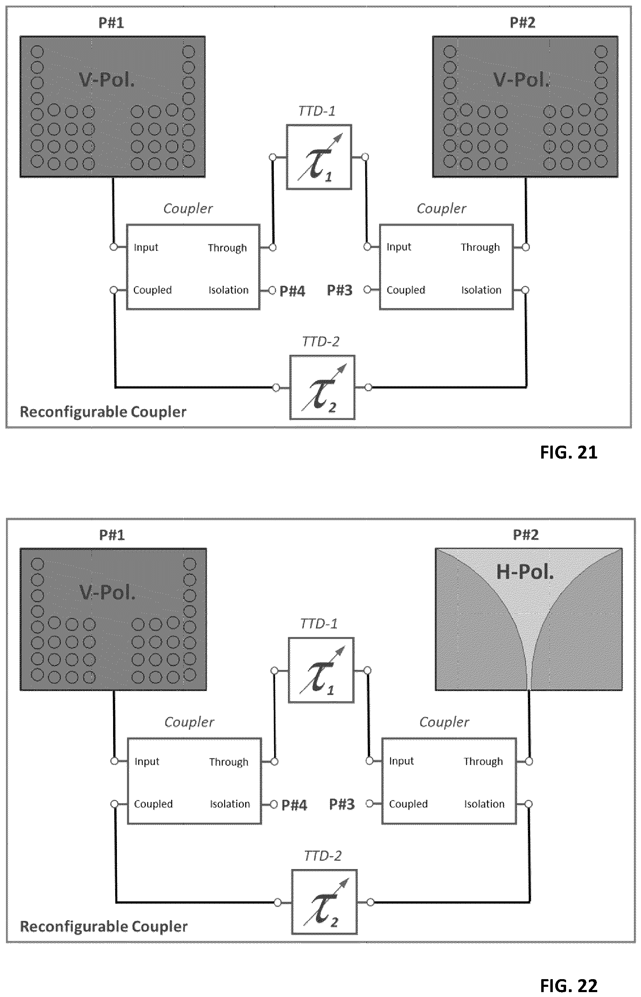

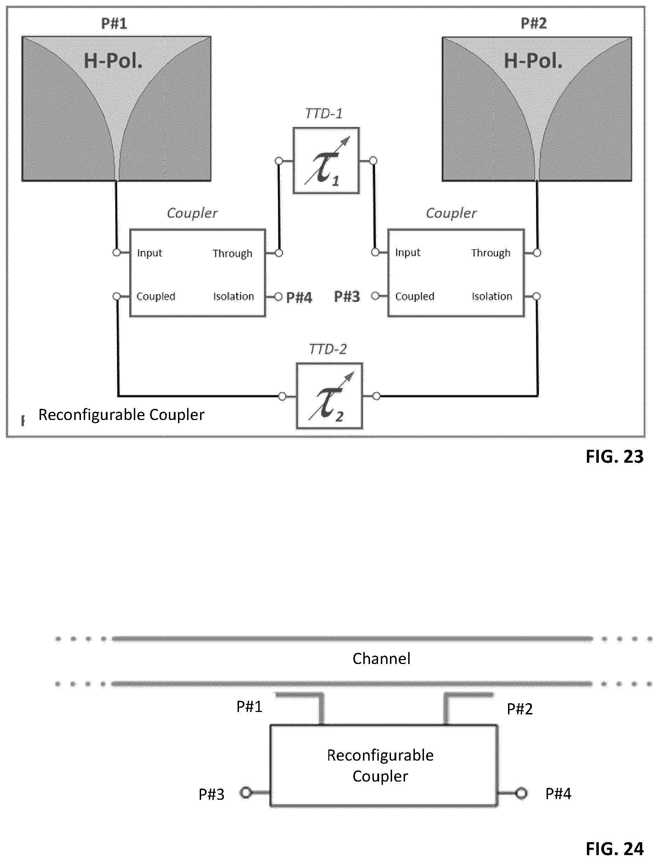

FIGs. 21-24 depicts architectures of reconfigurable couplers for dielectric (or magneto-dielectric) channels. Specifically, FIG. 21 depicts the reconfigurable coupler in a vertical-to-vertical polarization configuration. FIG. 22 depicts the reconfigurable coupler in a vertical-to-horizontal polarization configuration. FIG. 23 depicts the reconfigurable coupler in a horizontal-to-horizontal configuration. FIG. 24 depicts the reconfigurable coupler as an equivalent block diagram symbol.

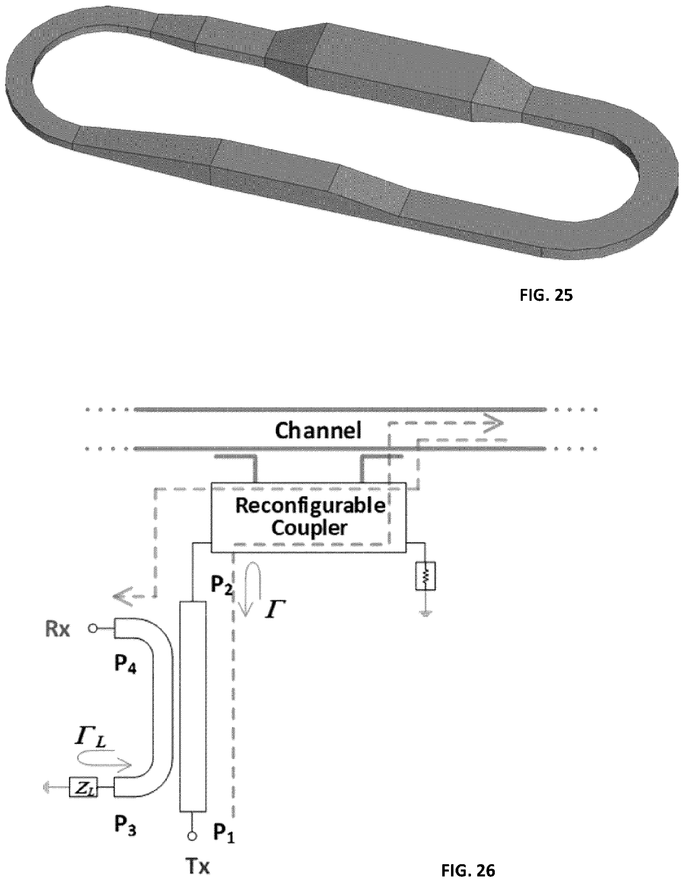

FIG. 25 depicts an example dielectric (or magneto-dielectric) channel varying width and/or height of the channel structures to support multimode excitations and dual polarization. Higher-order mode excitation requires wider width and/or higher height of the channel shape. Therefore, higher modes can only be excited at wider width and/or higher height sections of the channel. The excited higher-modes cannot pass through sections having a narrower width and/or lower height. This feature filters wave propagation modes, and their communication range is limited to higher order modes.

On the other hand, lower-order modes can pass the channel section that has a wider width and/or higher height. In other words, the fundamental mode can circulate the loop-shape channel, which can deliver controlling messages to other couplers or network nodes while higher-order mode can support burst high data throughputs between near-distance couplers (or network nodes).

The proposed software-defined reconfigurable channel architecture can support all duplex functions, such as time division duplex (TDD), frequency division duplex (FDD), and in-band full duplex (INFD) (simultaneous full duplex in both time and frequency). In particular, the INFD can double the data throughputs. In some circumstances, TDD and FDD can be considered as a sub-set of INFD.

FIG. 26 depicts an exemplary design block diagram. In this figure, an all-duplex function is implemented through a coupled-line directional coupler which is coupled (or coupled) to the channel through a reconfigurable coupler. In a simultaneous receiving mode, the signal depicts as being coupled to the Rx port (P4). Although some residual signals may also be coupled to the Tx (P1), the level of the residual signal would be significantly lower than that of the Tx signals. On the other hand, during a simultaneous transmitting mode, the residual Tx signals may interfere with the incoming Rx signals. This self-interference issue can be resolved by configuring the impedance load ($Z_L$) at port #3.

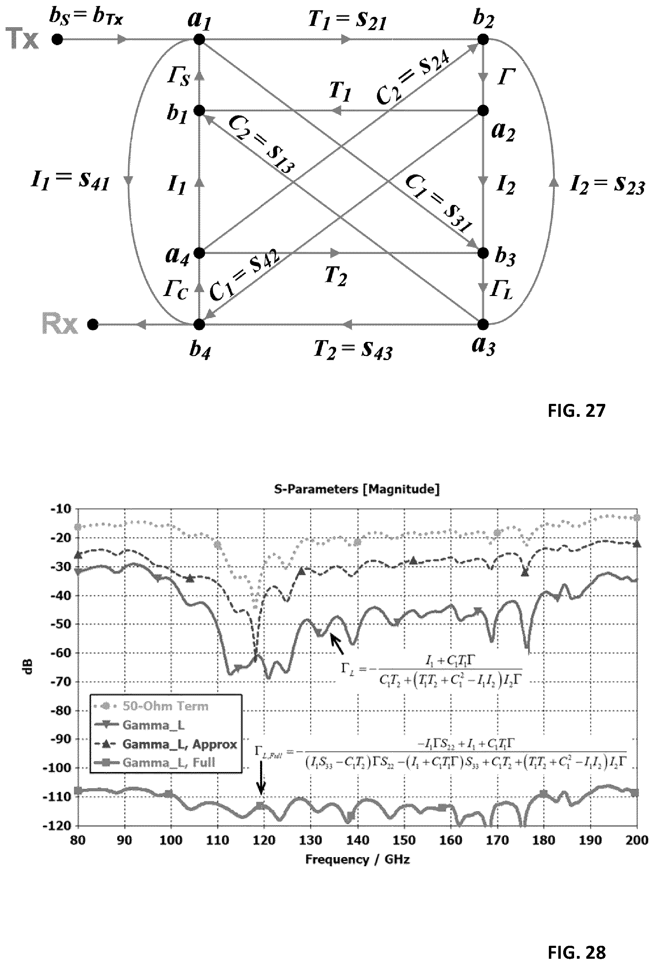

Regarding an analytic solution of optimum impedance load ($Z_L$) of a duplexer (implemented with a coupled-line coupler in our example), it is useful to consider the signal flow graph of FIG. 27. It may be desired to minimize self-interference from Tx port (P1) to Rx port (P4), i.e. b4/a1 = 0 (or as close to 0 as possible), in terms of power-wave representation in the Scattering matrix. In so doing, and ignoring $\Gamma_s$ (reflections from the power amplifier chain) and $\Gamma_c$ (reflections from the low-noise amplifier chain), it can be shown that the full analytic solution of the desired reflection coefficient ($\Gamma_L$) from the load impedance at P3 is found as the following in order to minimize the self-interference or b4/a1:

$$\Gamma_{L,Full} = -\frac{-I_1\Gamma S_{22} + I_1 + C_1 T_1\Gamma}{\left(I_1 S_{33} - C_1 T_2\right)\Gamma S_{22} - \left(I_1 + C_1 T_1\Gamma\right)S_{33} + C_1 T_2 + \left(T_1 T_2 + C_1^2 - I_1 I_2\right)I_2\Gamma} \tag{1}$$

Equation (1) can be considered as a theoretical isolation limit between Tx port (P1) and Rx port (P4) in FIG. 26. Then, the optimum load impedance ($Z_L$) can be found from the well-known relationship between impedance and the reflection coefficient:

$$Z_L = Z_0 \frac{1 + \Gamma_{L,Full}}{1 - \Gamma_{L,Full}} \tag{2}$$

where $Z_0$ is the reference impedance of the system.

The found load impedance needs to be synthesized with circuits to be implemented and further approximation is necessary for the circuit synthesis. Often, the resulting operational bandwidth of the synthesized circuit tends to become narrower. Ignoring the impedance mismatch at each port of the all-duplex coupler, i.e. S11 = S22 = S33 = S44 = 0 (or as close to 0 as possible), the full analytic solution of the load reflection coefficient can be simplified as the following:

$$\Gamma_L = -\frac{I_1 + C_1 T_1\Gamma}{C_1 T_2 + \left(T_1 T_2 + C_1^2 - I_1 I_2\right)I_2\Gamma} \tag{3}$$

In order to obtain the simplest case, beside the ignoring impedance mismatch at each port, it is useful to assume that all isolations, transmissions, and coupling coefficients are the same, i.e. I1 = I2 := I, I1 = I2 := I, T1 = T2 := T, and C1 = C2 := C. Then the simplest form of the approximated reflection coefficient is found as

$$\Gamma_{L,Approx} = -\frac{I + CT\Gamma}{CT + \left(C^2 + T^2 - I^2\right)I\Gamma} \tag{4}$$

The level of simplification of the full analytic solution in Equation (1) can be adjusted through multi-variable Taylor series expansion and additional assumption of reflection coefficients at ports, depending on the targeted level of isolation to achieve, e.g. taking the first two terms versus first three terms of the Taylor series expansion results.

In order to understand the impact of various load reflection equations for the self-interference level, simulations are performed for the example block diagrams in FIG. 26 with a duplexer (implanted using a 10-dB coupled-line coupler), a vertically polarized coupler, and reconfigurable 0-dB coupler. FIG. 28 depicts simulation results representing a comparison of Tx-Rx isolation results for the example block diagrams in FIG. 26 with a duplexer (implemented with a 10-dB coupled-line coupler), a vertically polarized coupler, and a reconfigurable 0-dB coupler (C = 0 dB) for various $Z_L$ conditions and corresponding $\Gamma_L$ solutions. FIG. 28 shows that the simplest reflection coefficient ($\Gamma_{L,Approx}$) solution does not provide enough Tx-Rx isolation for D-band all-duplex communications with high data throughputs (e.g. greater than 150 GHz). The full-solution reflection coefficient depicts more than 100 dB Tx-Rx isolation level for the entire D band (110 - 170 GHz), which basically represents the theoretical limit. The reflection coefficient solution in Equation (3) with S11 = S22 = S33 = S44 = 0 shows more than 40-dB Tx-Rx isolation for the entire D band, which would be practically sufficient for all-duplex communications in many application scenarios.

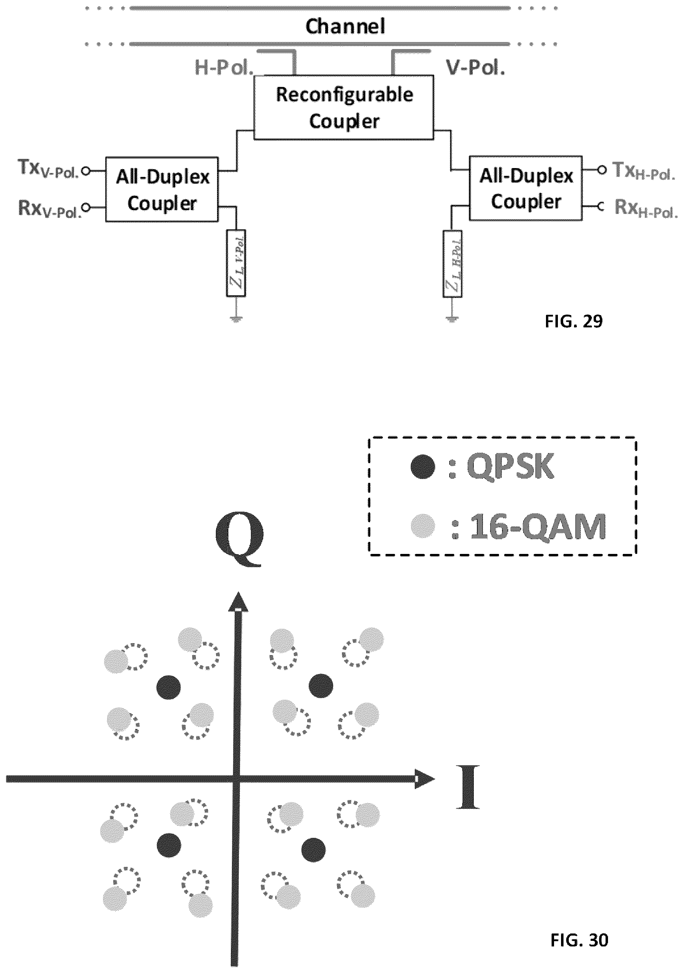

FIG. 29 depicts the integration of dielectric (or magneto-dielectric) channels, dual-polarized couplers, reconfigurable couplers, and impedance loads in a single chiplet. In this case, data throughputs can be increased greatly (essentially 4x), compared to a fixed width dielectric waveguide channel. In this figure, the example block diagram of a reconfigurable system utilizes two all-duplex couplers and a dual-polarization reconfigurable coupler for a dielectric (or magneto-dielectric) waveguide channel.

The above-referenced in-band, full-duplexing approaches are a cost-effective solution implemented with passive components, but they may suffer from a minimum of 3-dB insertion loss. Hence, these approaches may not be popular for conventional long-distance wireless communications. However, it can be attractive, together with the reconfigurable coupler, for communications between chiplets, dies, packages, or PCBs when an adjacent chiplet/die/-package/PCB needs bursty, high data throughputs, and the channel insertion loss is low, compared to traditional long-distance wireless communication.

The principles and methods disclosed herein support both control and data planes through hierarchical modulation. The control signals for the reconfigurable coupler can be combined with data signals through a hierarchical modulation. Consider FIG. 30, which depicts QPSK in a 16-quadrature-amplitude-modulation (16-QAM) signal constellation. A node with a high signal-to-noise ratio (SNR) can decode both QPSK and 16-QAM signals that are delivered through the channel. On the other hand, other nodes with a low SNR can only decode QPSK signals. The level of SNR at each receiver node can be set by the coupling coefficient of the reconfigurable couplers. Thus, control signals can be coded in QPSK and broadcast to all the nodes while data signals can be delivered to some designated nodes.

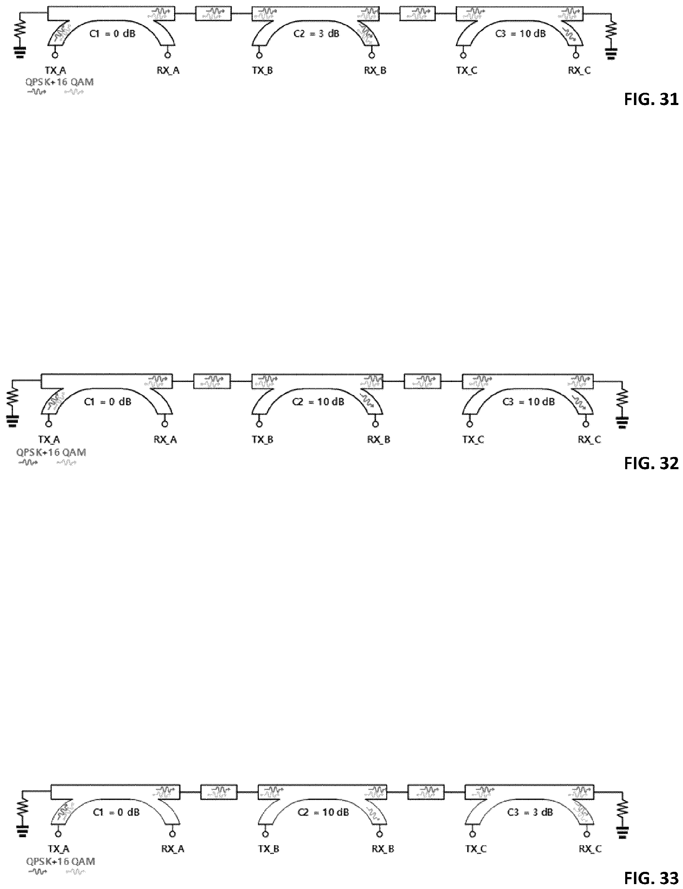

FIGs. 31-33 provide additional examples about how hierarchical modulation can deliver different information to different receiver nodes. In each of these figures, signals with QPSK + 16-QAM modulation are transferred from Tx_A. Rx_B with a 3-dB coupling coefficient can decode both QPSK and 16-QAM signals while Rx_C with a 10-dB coupling coefficient can only decode QPSK signals, as depicted in FIG. 31. In contrast to FIG. 31, FIG. 32 depicts both Rx_B and Rx_C with a 10-dB coupling coefficient that allows the device to decode QPSK signals. In FIG. 33, another example is depicted, in which both QPSK and 16-QAM signals can only be decoded at Rx_C.

The hierarchical modulation not only offers a way to combine control and data information, but also provides an opportunity to control effective throughput/bandwidth at each node. This is a highly desirable feature in a wireless chiplet-to-chiplet communications to offer energy-efficient information delivery to each node.

FIGs. 31-33 depicts various examples of control and data information delivery to different, targeted chiplets through QPSK in 16-QAM hierarchical modulation. For example, in FIG. 31, QPSK and 16-QAM signals are sent from TX-A and travel across the network, where they are each received by RX_B. The QPSK signal (but not the 16-QAM signal) is further received at RX_C. In FIG. 32, QPSK and 16-QAM signals are sent from TX-A and continue traveling through the network. The QPSK signal (but not the 16-QAM signal) is received at RX_B and at RX_C. In FIG. 33, QPSK and 16-QAM signals are sent from TX-A and travel across the network, where the QPSK signal (but not the 16-QAM signal) is received by RX_B. Both signals continue to travel through the network and are each received at RX_C. This is owing to the description, above, that the channel may be designed with different mode or frequency limitations that may result in a higher-order mode being essentially filtered out, while a lower-order mode or a fundamental mode is permitted to pass. Notably, QPSK signals can propagate an enough signal-to-noise ratio to still be decoded at longer ranges, as compared to the range of 16 QAM signals (which requires a higher SNR than QPSK to be decoded) and is thus limited. Given then, the QPSK signals in FIGs 31 - 33 can be decoded at both RX_B and RX_C. However, depending on the coupling coefficient configuration of the couplers in the network, 16 QAM signal decoding is only possible at RX_B (see FIG. 31) or at RX_C (see FIG. 33).

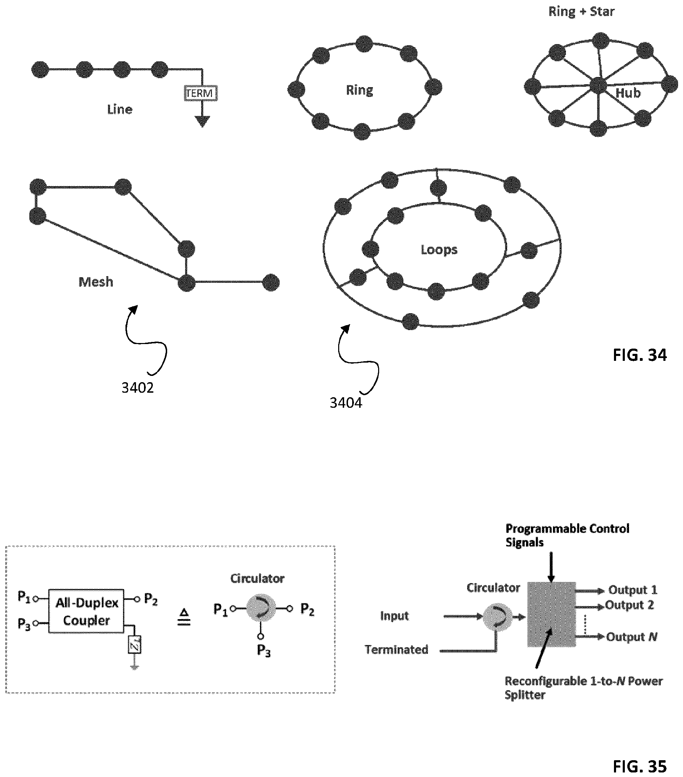

The relevant network topologies may be flexible and can take various forms. FIG. 34 depicts two exemplary forms of network topologies, although any form or combination of forms is possible. In this figure, a first network topology is shown as a mesh 3402 and a second network topology is shown as a series of loops 3404. These are merely provided for exemplary purposes. It is expressly noted that any network topology used with the principles and methods disclosed herein could be implemented as a mesh, as a loop or series of loops, as any combination of mesh and loops, or in any other network topology desired. That is, the principles and methods disclosed herein can be implemented in any network topology.

Fig. 35 depicts a reconfigurable unilateral multidrop network. In this figure, the input signal may be a congregated N-multiband signal, a serialized signal, or a single carrier data. Through a reconfigurable power splitter, the input signal is split into N outputs propagating towards N different destinations. The reconfigurable splitter determines the destination and power level for each signal output.

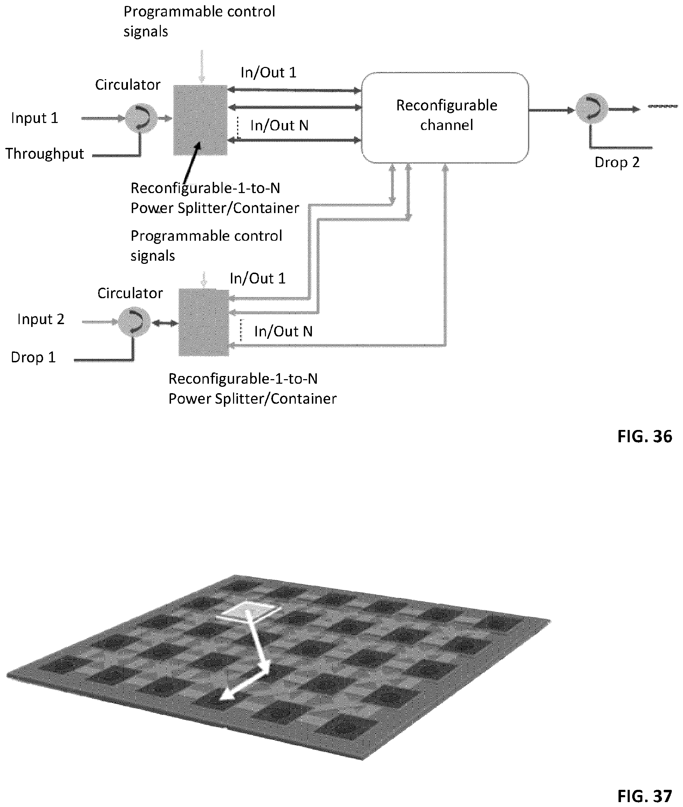

The topology presented in FIG. 35 can be augmented into a multi-directional network as illustrated in FIG. 36, such as through a reconfigurable channel. For instance, "Input1" can be chosen to be dropped either at "Drop1" or "Drop2", or both. Similarly, "Input 2" can propagate to both "Through" and "Drop2". Alternatively, both "Input1" and "Input2" can be multiplexed by the reconfigurable channel and delivered to "Drop 2".

FIG. 36 depicts a reconfigurable multidrop/point-point network, according to an aspect of the disclosure. In this figure, Input 1 may be directed via a circulator through a number of input channels into the reconfigurable channel. The signal may travel through the reconfigurable channel to be directed to a desired output point. Similarly, Input 2 may be directed via a circulator through a number of input channels into the reconfigurable channel. This process may also operate in reverse, wherein a signal is received from the reconfigurable channel and then is distributed via the circulator to the appropriate drop position.

FIG. 37 shows an example scenario of chip-to-chip communication in die/package/PCB level. The complex network topology is supported with reconfigurable couplers and transmission line network in die/package/ PCB layers. With the support of complex network topologies, the proposed reconfigurable channel can be readily extended to the system beyond chiplet-chiplet, die-die, package-package, and PCB-PCB communications. The software-defined reconfigurable channel also allows communications between chiplet, dies, package, and the PCB.

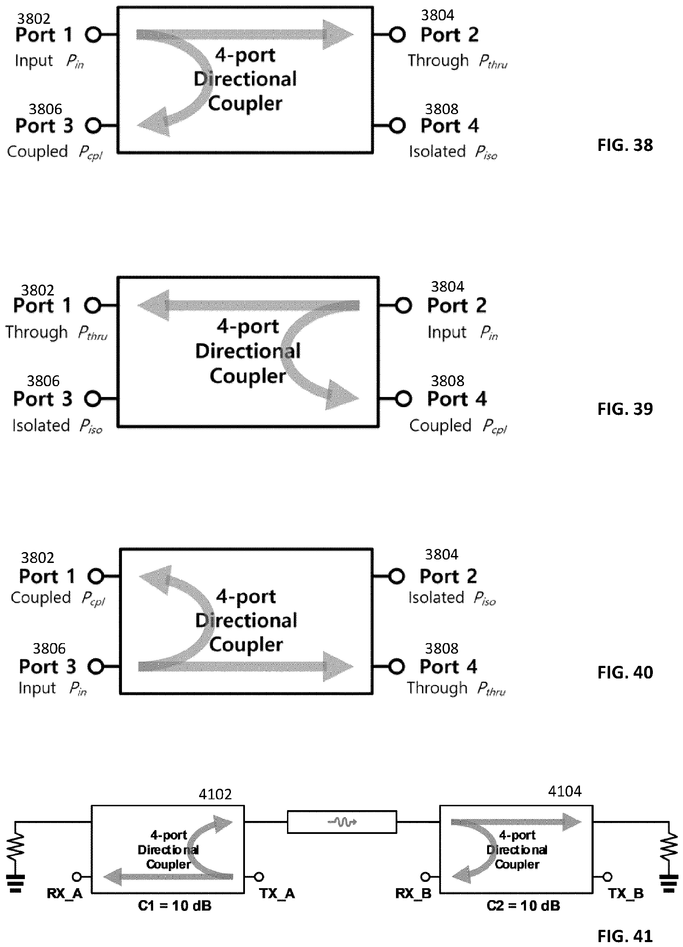

Attention will now be turned to the underlying concepts of the software-defined reconfigurable channels between chiplets, die, package, or PCB. Starting from a simple, exemplary directional coupler (or bi-directional coupler), the following will explain how the software-defined reconfigurable channel supports a simple communication link, channel isolator (termination), multidrop, point-to-point communication, and network segmentation. FIG. 38 depicts a directional coupler. This directional coupler is depicted as having a first port 3802, a second port 3804, a third port 3806, and a fourth port (an isolated port) 3808. Thus, the directional coupler is a 4-port device which can split the incident power from input port to output port and coupled port.

The coupling factor C is defined as the ratio of the input power (Pin) to the coupled power (Pcpl) as below:

$$C = 10 \log_{10} \frac{P_{in}}{P_{cpl}} \ \ (\text{dB}) \tag{5}$$

That is, a 10-dB coupler splits 1/10th of input power into the coupled port, and 9/10th of the input power into the through port. There is no power (or essentially no power) flowing into isolation port, which provides a matched termination.

Based on the symmetry (and microwave theory), the signal power from any port has the same power-splitting property. FIG. 39 depicts a signal flow when the power is driven from port 2. Assuming 10-dB coupler, 1/10th of the power goes into port 4 and 9/10th of the power goes into port 1, showing symmetry around vertical axis when compared to FIG. 38.

Similarly, FIG. 40 shows signal flow when the power is driven from port 3. Assuming a 10-dB coupler, 1/10th of the power goes into port 1, and 9/10th of the power goes into port 4, showing symmetry around horizontal axis when compared to FIG. 38.

A communication channel can be formed with directional couplers and a shared guided-wave structure (e.g. waveguide or transmission line with proper interface). A transceiver can be attached to each directional coupler to have communication link.

FIG. 41 depicts an example of a simple communication link formed by two transceivers (not depicted) and two directional couplers (4102 and 4104) and a transmission line with proper terminations. TX_A sends the signal power to the channel through a coupler with a coupling coefficient = 10 dB. Therefore, 1/10th of the power flows into the channel with a direction towards the 2nd coupler, where RX_B is coupled. In the 2nd coupler, of which the coupling coefficient is also 10 dB, the signal received from the channel will couple and deliver to the port with RX_B.

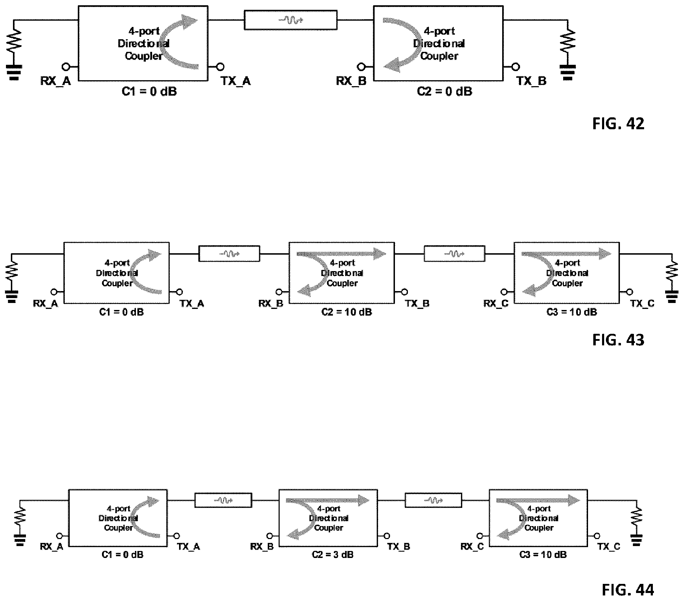

FIG. 42 depicts the same communication channel configuration with 0-dB couplers. A 0-dB coupler theoretically sends all the power to the coupled port, such that all signal power from TX_A is delivered to RX_B, assuming a lossless channel, unlike the case mentioned above with 10-dB couplers. It is also worthwhile to note that 0 dB coupler acts as a channel isolator, as it does not leak any signal to the other side of the channel. Of course, this is described as the ideal situation, and a real world implementation may not achieve exactly 0-dB coupling, but may rather merely approximate it.

In an optional configuration, the directional couplers can be cascaded in the channel so that point-to-multipoint communication is supported. FIG. 43 depicts such a cascaded configuration of directional couplers that includes 1 transmitter and 2 receivers. Note that the first coupler as TX is configured to have a 0 dB coupling coefficient, and the second and the third couplers are configured to have a 10 dB coupling coefficient. In this configuration, the signal power from TX_A flows into the channel, and RX_B receives 1/10th of the power and RX_C receives 9/100th of the power. The concept can support more receivers in such a way that effective permits broadcasting (1-to-N communication) in the wireless channel.

Different amounts of signal energy can be delivered to different receivers by configuring the coupling coefficient differently. FIG. 44 depicts an example case of a 1:2 communication link, wherein the first receiver (RX_B) is configured to have a 3 dB coupling, and the second receiver (RX_C) is configured to have 10 dB coupling. In this configuration, RX_B receives 50% of TX power and RX_C receives 5%, having different signal-to-noise ratios (SNR) at each RX input. This flexibility in the channel serves as resource allocation in terms of signal power, and it effectively mimics beam-steering feature in wireless channel with phased-array transceiver where signal energy is focused on a single direction.

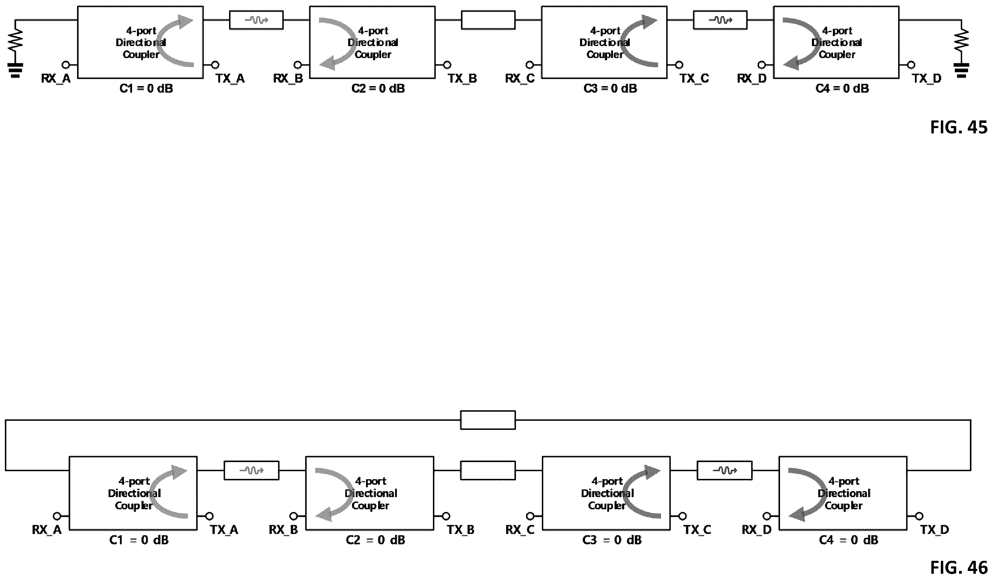

Even multiple 1: 1 communication links can be supported with directional couplers with adjustable coupling coefficients. Set to have 0 dB coupling coefficient, the directional couplers serve as an ideal signal source and an ideal signal load, preventing any leakage signal to the other side of the channel. In FIG. 45, where 4 transceivers are coupled to the channel with directional couplers in cascaded fashion, two different 1: 1 (point-to-point) communication links can be supported with two independent signal flows as they are not mixed in the channel. The channel is thus effectively sectorized into multiple transmission media, which serve the same purpose as spatial-multiplexing in wireless communication with phased-array transceiver.

In addition, as the 0 dB coupler serves as ideal load, the terminations at each end of the channel can be removed and coupled to form a circular channel. FIG. 46 depicts such a formation without loss of functionality in supporting two 1: 1 communication links. With the circular channel formation, the flexibility of link configuration is increased, as different pairs of transceivers can form the link (e.g. TX_D to RX_A).

The configurations that have shown so far are in most exemplary, and the concept can support more degrees of freedom without compromising the core idea of the proposed invention. For example, in TDD multiplexing, each transmitter or receiver node can be coupled to one transceiver (TRX_A in TX_A, TRX_B in RX_A, TRX_C in TX_B, etc.). Also, the directional coupler can be reconfigurable or be any combination of coupler and switch in any topology.

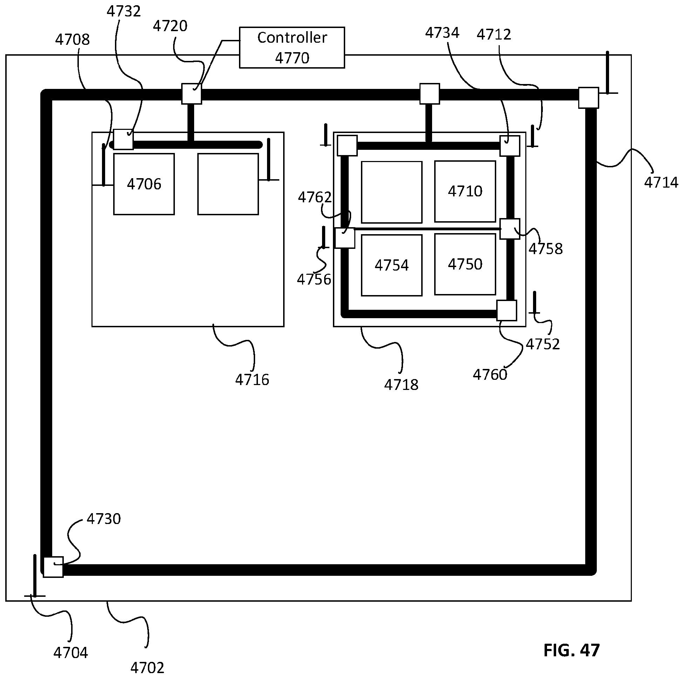

The waveguide and the configurable coupler may be implemented as part of an integrated chiplet system. FIG. 47 depicts an integrated chiplet system that includes a printed circuit board (PCB) 4702, including a first antenna 4704; a first chiplet 4706, electrically conductively coupled to a second antenna 4708; a second chiplet 4710, electrically conductively coupled to a third antenna 4712; and a waveguide 4714, configured to direct a signal from the first antenna 4704 to the second antenna 4708 or the third antenna 4712.

The integrated chiplet system may further include a first chip package 4716 that includes the first chiplet 4706 and the second antenna 4708. The integrated chiplet system may further include a second chip package 4718, which itself may further include the second chiplet 4710 and the third antenna 4712. The integrated chiplet system may include a directional coupler 4720, which may be configured to direct a greater portion of the signal to the second antenna 4708 than to the third antenna 4712, or to direct a greater portion of the signal to the third antenna 4712 than to the second antenna 4708.

The integrated chiplet system may be configured such that the waveguide 4714 includes a first port 4730, adjacent to the first antenna 4704; a second port 4732, adjacent to the second antenna 4708; and a third port 4734, adjacent to the third antenna 4712. The directional coupler 4720 may be configured to receive the signal from the first port 4730 and to direct the signal to the second port 4732 or the third port 4734. As depicted herein, in this exemplary configuration, the directional coupler 4720 may direct most or all of the incoming signal (e.g., the signal from the first antenna 4704) toward the second port 4732 and thereby to the second antenna 4708. Alternatively, the directional coupler 4720 may direct most or all of the incoming signal toward the third port 4734 and thereby to the third antenna 4712. In this particular configuration, the directional coupler 4720 directing the signal to the third port 4734 may mean directing the signal to one or more additional directional couplers, such as in a configuration in which directional couplers are cascaded.

That is, the integrated chiplet system may include cascaded directional couplers. As an example thereof, it may further include a third chiplet 4750, electrically conductively coupled to a fourth antenna 4752; and a fourth chiplet 4754, electrically conductively coupled to a fifth antenna 4756. In this manner, the directional coupler 4720 may be a first directional coupler. There may also be a second directional coupler 4758. The integrated chiplet system may further include a fourth port 4760, adjacent to the fourth antenna 4752; and a fifth port 4762, adjacent to the fifth antenna 4756. In this manner, the second directional coupler 4758 may be is configured to receive the output of the third port 4734 and to direct the output of the third port 4734 to the fourth port 4760 or the fifth port 4762.

The directional coupler 4720 may be configured to selectively direct a greater portion of the signal to the second antenna 4708 than to the third antenna 4712, and subsequently to direct a greater portion of the signal to the third antenna 4712 than to the second antenna 4708.

The integrated chiplet system may optionally include a controller 4770, which may be configured to change a coupling coefficient of the directional coupler. In this manner, the coupling coefficient may determine a magnitude of the signal directed to the second antenna and a magnitude of the signal directed to the third antenna. The controller 4770 may be configured to control the directional coupler to exhibit a first coupling coefficient for a first signal according to a first modulation scheme and to exhibit a second coupling coefficient for a second signal according to a second modulation scheme. The first coupling coefficient may be greater than the second coupling coefficient. As such, the first modulation scheme may have a higher throughput than the second modulation scheme. The controller 4770 may include a processor that is configured to execute code, in which the code specifies changes in the coupling coefficient(s) for the directional coupler, or in which the code specifies procedures to change the coupling coefficient(s) for the directional coupler. The controller may include a non-transitory computer readable medium, comprising instructions which, if executed by a processor, cause the processor to selectively change a coupling coefficient of the directional controller.

The waveguide may be a metallic waveguide, a dielectric waveguide, or a magneto-dielectric waveguide. The directional coupler may include a vertical-to-vertical coupling structure, a horizontal-to-horizontal coupling structure, or a vertical-to-horizontal coupling structure.

The signal may be a first signal. In this manner, the directional coupler may be configured to send the first signal in a first direction along a path, and to concurrently send a second signal in a second direction along the path. In this configuration, the second direction may travel in an opposite direction to the first direction.

The waveguide may be placed in any position or shape relative to the PCB, the packages, or the chips. The waveguide may form an outline of a closed, polygonal shape; in this manner, the first antenna or the second antenna may be located inside the closed, polygonal shape. The chiplets of the respective antennas may be located in close proximity to the polygonal shape. Alternatively or additionally, the waveguide may form a circular or elliptical shape. In this manner, one of the first chiplet or the second chiplet may be located inside the circular or elliptical shape. Alternatively or additionally, one of the first chiplet or the second chiplet may be located along an outside of the circular or elliptical shape. Alternatively or additionally, the waveguide may combine both a closed polygon shape and an elliptical shape or a circular shape.

The waveguide may be configured with varying widths or heights. In this manner, a first portion of the waveguide may have a first width, and a second portion of the waveguide may have a second width, less than the first width. In this manner, the waveguide may exhibit selection for one or more modes (e.g., allowing signals in one or more modes to pass through the waveguide) while dampening signals of higher-order modes or otherwise preventing signals of other modes from passing. Alternatively or additionally, this may also be achieved with height. In this manner, the waveguide may be configured to operate according to a first mode and a second mode; wherein the second mode is a higher-order mode than the first mode; and wherein a signal according to the first mode can pass through the first portion but cannot pass through the second portion; and wherein a signal according to the second mode can pass through both the first portion and the second portion. The determination of whether the waveguide exhibits selectively based on width or height may depend on whether an incoming signal is vertically polarized or horizontally polarized.

Alternatively or additionally, the waveguide may be frequency banded. In this manner, the waveguide may include a first portion and a second portion, and the first portion may form a frequency-banded channel for a first range of frequencies, and the second portion may form a frequency banded channel for a second range of frequencies, different from the first range of frequencies.

Further aspects of the disclosure will be shown by way of Examples.

In Example 1, an integrated chiplet system, including a printed circuit board (PCB), a first antenna; a first chiplet, electrically conductively coupled to a second antenna; a second chiplet, electrically conductively coupled to a third antenna; and a waveguide, configured to direct a signal from the first antenna to the second antenna or the third antenna.

In Example 2, the integrated chiplet system of Example 1, further including: a first chip package, including the first chiplet and the second antenna; and a second chip package, including the second chiplet and the third antenna.

In Example 3, the integrated chiplet system of Example 1 or 2, further including a directional coupling means, configured to direct a greater portion of the signal to the second antenna than to the third antenna, or to direct a greater portion of the signal to the third antenna than to the second antenna.

In Example 4, the integrated chiplet system of Example 3, wherein the waveguide includes: a first port, adjacent to the first antenna; a second port, adjacent to the second antenna; and a third port, adjacent to the third antenna; wherein the directional coupling means is configured to receive the signal from the first port and to direct the signal to the second port or the third port.

In Example 5, the integrated chiplet system of Example 4, further including a third chiplet, electrically conductively coupled to a fourth antenna; and a fourth chiplet, electrically conductively coupled to a fifth antenna; wherein the directional coupling means is a first directional coupling means; further including a second directional coupling means; a fourth port, adjacent to the fourth antenna; and a fifth port, adjacent to the fifth antenna; wherein the directional coupling means is configured to receive the output of the third port and to direct the output of the third port to the fourth port or the fifth port.

In Example 6, the integrated chiplet system of any one of Examples 3 to 5, wherein the directional coupling means is configured to selectively direct a greater portion of the signal to the second antenna than to the third antenna, and subsequently to direct a greater portion of the signal to the third antenna than to the second antenna.

In Example 7, the integrated chiplet system of any one of Examples 4 to 6, further including a controller, configured to change a coupling coefficient of the directional coupling means, wherein the coupling coefficient determines a magnitude of the signal directed to the second antenna and a magnitude of the signal directed to the third antenna.

In Example 8, the integrated chiplet system of Example 7, wherein the controller is configured to control the directional coupling means to exhibit a first coupling coefficient for a first signal according to a first modulation scheme and to exhibit a second coupling coefficient for a second signal according to a second modulation scheme.

In Example 9, the integrated chiplet system of Example 8, wherein the first coupling coefficient is greater than the second coupling coefficient; and wherein the first modulation scheme has a higher throughput than the second modulation scheme.

In Example 10, the integrated chiplet system of any one of Examples 1 to 9, wherein the waveguide is a metallic waveguide.

In Example 11, the integrated chiplet system of any one of Examples 1 to 9, wherein the waveguide is a dielectric waveguide.

In Example 12, the integrated chiplet system of any one of Examples 1 to 9, wherein the waveguide is a magneto-dielectric waveguide.

In Example 13, the integrated chiplet system of Example 11 or 12, wherein the directional coupling means includes a vertical-to-vertical coupling structure, a horizontal-to-horizontal coupling structure, and a vertical-to-horizontal coupling structure.

In Example 14, the integrated chiplet system of any one of Examples 11 to 12, wherein the signal is a first signal; wherein directional coupling means is configured to send the first signal in a first direction along a path, and wherein the directional coupling means is configured to concurrently send a second signal in a second direction along the path; wherein the second direction is opposite the first direction.

In Example 15, the integrated chiplet system of any one of Examples 1 to 12, wherein the waveguide forms an outline of a closed, polygonal shape, and wherein one of the first chiplet or the second chiplet is within the closed, polygonal shape.

In Example 16, the integrated chiplet system of any one of Examples 1 to 12, wherein the waveguide forms an outline of a closed, polygonal shape, and wherein one of the first chiplet or the second chiplet is outside of the closed, polygonal shape.

In Example 17, the integrated chiplet system of any one of Examples 1 to 12, wherein the waveguide forms a circular or elliptical shape, and wherein one of the first chiplet or the second chiplet is within the circular or elliptical shape.

In Example 18, the integrated chiplet system of any one of Examples 1 to 12, wherein the waveguide forms a circular or elliptical shape, and wherein one of the first chiplet or the second chiplet is outside of the circular or elliptical shape.

In Example 19, the integrated chiplet system of any one of Examples 12 to 18, wherein the waveguide combines a closed polygon shape with an elliptical shape or a circular shape.

In Example 20, the integrated chiplet system of any one of Examples 1 to 17, wherein a first portion of the waveguide has a first width and a second portion of the waveguide has a second width, less than the first width.

In Example 21, the integrated chiplet system of Example 20, wherein the waveguide is configured to operate according to a first mode and a second mode; wherein the second mode is a higher-order mode than the first mode; and wherein a signal according to the first mode can pass through the first portion but cannot pass through the second portion; and wherein a signal according to the second mode can pass through both the first portion and the second portion.

In Example 22, the integrated chiplet system of any one of Examples 1 to 19, wherein the waveguide includes a first portion and a second portion, and wherein the first portion forms a frequency banded channel for a first range of frequencies, and wherein the second portion forms a frequency banded channel for a second range of frequencies, different from the first range of frequencies.

In Example 23, an integrated chiplet system, including: a printed circuit board (PCB), including a first antenna; a first chiplet, electrically conductively coupled to a second antenna; a second chiplet, electrically conductively coupled to a third antenna; and a waveguide, configured to direct a signal from the first antenna to the second antenna or the third antenna.

In Example 24, the integrated chiplet system of Example 23, further including: a first chip package, including the first chiplet and the second antenna; and a second chip package, including the second chiplet and the third antenna.

In Example 25, the integrated chiplet system of Example 23 or 24, further including a directional coupling means, configured to direct a greater portion of the signal to the second antenna than to the third antenna, or to direct a greater portion of the signal to the third antenna than to the second antenna.

In Example 26, the integrated chiplet system of Example 25, wherein the waveguide includes: a first port, adjacent to the first antenna; a second port, adjacent to the second antenna; and a third port, adjacent to the third antenna; wherein the directional coupling means is configured to receive the signal from the first port and to direct the signal to the second port or the third port.

In Example 27, the integrated chiplet system of Example 26, further including a third chiplet, electrically conductively coupled to a fourth antenna; and a fourth chiplet, electrically conductively coupled to a fifth antenna; wherein the directional coupling means is a first directional coupling means; further including a second directional coupling means; a fourth port, adjacent to the fourth antenna; and a fifth port, adjacent to the fifth antenna; wherein the directional coupling means is configured to receive the output of the third port and to direct the output of the third port to the fourth port or the fifth port.

In Example 28, the integrated chiplet system of any one of Examples 25 to 27, wherein the directional coupling means is configured to selectively direct a greater portion of the signal to the second antenna than to the third antenna, and subsequently to direct a greater portion of the signal to the third antenna than to the second antenna.

In Example 29, the integrated chiplet system of any one of Examples 26 to 28, further including a controller, configured to change a coupling coefficient of the directional coupling means, wherein the coupling coefficient determines a magnitude of the signal directed to the second antenna and a magnitude of the signal directed to the third antenna.

In Example 30, the integrated chiplet system of Example 29, wherein the controller is configured to control the directional coupling means to exhibit a first coupling coefficient for a first signal according to a first modulation scheme and to exhibit a second coupling coefficient for a second signal according to a second modulation scheme.

In Example 31, the integrated chiplet system of Example 30, wherein the first coupling coefficient is greater than the second coupling coefficient; and wherein the first modulation scheme has a higher throughput than the second modulation scheme.

In Example 32, the integrated chiplet system of any one of Examples 23 to 31, wherein the waveguide is a metallic waveguide.

In Example 33, the integrated chiplet system of any one of Examples 23 to 31, wherein the waveguide is a dielectric waveguide.

In Example 34, the integrated chiplet system of any one of Examples 23 to 31, wherein the waveguide is a magneto-dielectric waveguide.

In Example 35, the integrated chiplet system of Example 33 or 34, wherein the directional coupling means includes a vertical-to-vertical coupling structure, a horizontal-to-horizontal coupling structure, and a vertical-to-horizontal coupling structure.

In Example 36, the integrated chiplet system of any one of Examples 33 to 34, wherein the signal is a first signal; wherein directional coupling means is configured to send the first signal in a first direction along a path, and wherein the directional coupling means is configured to concurrently send a second signal in a second direction along the path; wherein the second direction is opposite the first direction.

In Example 37, the integrated chiplet system of any one of Examples 23 to 34, wherein the waveguide forms an outline of a closed, polygonal shape, and wherein one of the first chiplet or the second chiplet is within the closed, polygonal shape.

In Example 38, the integrated chiplet system of any one of Examples 23 to 34, wherein the waveguide forms an outline of a closed, polygonal shape, and wherein one of the first chiplet or the second chiplet is outside of the closed, polygonal shape.

In Example 39, the integrated chiplet system of any one of Examples 23 to 34, wherein the waveguide forms a circular or elliptical shape, and wherein one of the first chiplet or the second chiplet is within the circular or elliptical shape.

In Example 40, the integrated chiplet system of any one of Examples 23 to 34, wherein the waveguide forms a circular or elliptical shape, and wherein one of the first chiplet or the second chiplet is outside of the circular or elliptical shape.

In Example 41, the integrated chiplet system of any one of Examples 34 to 40, wherein the waveguide combines a closed polygon shape with an elliptical shape or a circular shape.

In Example 42, the integrated chiplet system of any one of Examples 23 to 39, wherein a first portion of the waveguide has a first width and a second portion of the waveguide has a second width, less than the first width.

In Example 43, the integrated chiplet system of Example 42, wherein the waveguide is configured to operate according to a first mode and a second mode; wherein the second mode is a higher-order mode than the first mode; and wherein a signal according to the first mode can pass through the first portion but cannot pass through the second portion; and wherein a signal according to the second mode can pass through both the first portion and the second portion.

In Example 44, the integrated chiplet system of any one of Examples 23 to 41, wherein the waveguide includes a first portion and a second portion, and wherein the first portion forms a frequency banded channel for a first range of frequencies, and wherein the second portion forms a frequency banded channel for a second range of frequencies, different from the first range of frequencies.

In Example 45, a method of directing a signal in an integrated chiplet system, including: providing a waveguide that is configured to selectively direct a signal from a first antenna to a second antenna or a third antenna; wherein the first antenna is configured to receive signals from, or send signal to, a printed circuit board (PCB), a second antenna, wherein the second antenna is configured to receive signals from, or send signals to, a first chiplet; and a third antenna, wherein the third antenna is configured to receive signals from, or send signals to, a second chiplet.

In Example 46, the method of Example 45, further comprising: a first chip package, including the first chiplet and the second antenna; and a second chip package, including the second chiplet and the third antenna.

In Example 47, the method of Example 45 or 46, further comprising selectively directing a greater portion of the signal to the second antenna than to the third antenna, or selectively directing a greater portion of the signal to the third antenna than to the second antenna.

In Example 48, the method of Example 47, wherein the directional coupler is configured to receive the signal from a first port of the waveguide and to direct the signal to a second port of the waveguide or a third port of the waveguide.

While the above descriptions and coupled figures may depict components as separate elements, skilled persons will appreciate the various possibilities to combine or integrate discrete elements into a single element. Such may include combining two or more circuits for form a single circuit, mounting two or more circuits onto a common chip or chassis to form an integrated element, executing discrete software components on a common processor core, etc. Conversely, skilled persons will recognize the possibility to separate a single element into two or more discrete elements, such as splitting a single circuit into two or more separate circuits, separating a chip or chassis into discrete elements originally provided thereon, separating a software component into two or more sections and executing each on a separate processor core, etc.

It is appreciated that implementations of methods detailed herein are demonstrative in nature, and are thus understood as capable of being implemented in a corresponding device. Likewise, it is appreciated that implementations of devices detailed herein are understood as capable of being implemented as a corresponding method. It is thus understood that a device corresponding to a method detailed herein may include one or more components configured to perform each aspect of the related method.

All acronyms defined in the above description additionally hold in all claims included herein.

**Claims**

1. An integrated chiplet system, comprising:

   a printed circuit board (PCB), comprising a first antenna;
   a first chiplet, electrically conductively coupled to a second antenna;
   a second chiplet, electrically conductively coupled to a third antenna; and
   a waveguide, configured to direct a signal from the first antenna to the second antenna or the third antenna.

2. The integrated chiplet system of claim 1, further comprising:

   a first chip package, comprising the first chiplet and the second antenna; and
   a second chip package, comprising the second chiplet and the third antenna.

3. The integrated chiplet system of any one of claims 1 or 2, further comprising:
   a directional coupler, configured to selectively direct a greater portion of the signal to the second antenna than to the third antenna, or to direct more of the signal to the third antenna than to the second antenna.

4. The integrated chiplet system of claim 3,

   wherein the waveguide comprises:

      a first port, adjacent to the first antenna;
      a second port, adjacent to the second antenna; and
      a third port, adjacent to the third antenna; and

   wherein the directional coupler is configured to receive the signal from the first port and to direct the signal to the second port or the third port;
   preferably the integrated chiplet system further comprising a third chiplet, electrically conductively coupled to a fourth antenna; and a fourth chiplet, electrically conductively coupled to a fifth antenna;
   wherein the directional coupler is a first directional coupler;
   further comprising a second directional coupler; a fourth port, adjacent to the fourth antenna; and a fifth port, adjacent to the fifth antenna; and
   wherein the directional coupler is configured to receive an output of the third port and to direct the output of the third port to the fourth port or the fifth port.

5. The integrated chiplet system of any one of claims 3 or 4,

   wherein the directional coupler is configured to selectively direct more of the signal to the second antenna than to the third antenna, and subsequently to direct more of the signal to the third antenna than to the second antenna;
   preferably the integrated chiplet system further comprising a controller, configured to change a coupling coefficient of the directional coupler, wherein the coupling coefficient determines a magnitude of the signal directed to the second antenna and a magnitude of the signal directed to the third antenna.

6. The integrated chiplet system of claim 5,

   wherein the controller is configured to control the directional coupler to exhibit a first coupling coefficient for a first signal according to a first modulation scheme and to exhibit a second coupling coefficient for a second signal according to a second modulation scheme;

preferably wherein the first coupling coefficient is greater than the second coupling coefficient; and wherein the first modulation scheme has a higher throughput than the second modulation scheme.

7. The integrated chiplet system of any one of claims 3 to 6,
wherein the directional coupler comprises a vertical-to-vertical coupling structure, a horizontal-to-horizontal coupling structure, and/or a vertical-to-horizontal coupling structure.

8. The integrated chiplet system of any one of claims 3 to 7,
wherein the signal is a first signal; wherein directional coupler is configured to send the first signal in a first direction along a path; and wherein the directional coupler is configured to concurrently send a second signal in a second direction along the path; wherein the second direction is opposite the first direction.

9. The integrated chiplet system of any one of claims 1 to 8,
wherein the waveguide forms an outline of a closed, polygonal shape, a circular shape, or an elliptical shape, and wherein one of the first chiplet or the second chiplet is within the closed, polygonal shape, the circular shape, or the elliptical shape.

10. The integrated chiplet system of any one of claims 1 to 9,
wherein the waveguide forms an outline of a closed, polygonal shape, a circular shape, or an elliptical shape, and wherein one of the first chiplet or the second chiplet is outside of the closed, polygonal shape, the circular shape, or the elliptical shape.

11. The integrated chiplet system of any one of claims 1 to 10,
wherein the waveguide combines a closed polygon shape with an elliptical shape or a circular shape.

12. The integrated chiplet system of any one of claims 1 to 11,

wherein a first portion of the waveguide has a first width and a second portion of the waveguide has a second width, less than the first width;
preferably wherein the waveguide is configured to operate according to a first mode and a second mode; wherein the second mode is a higher-order mode than the first mode; and wherein a signal according to the first mode can pass through the first portion but cannot pass through the second portion; and wherein a signal according to the second mode can pass through both the first portion and the second portion.

13. The integrated chiplet system of any one of claims 1 to 12,
wherein the waveguide comprises a first portion and a second portion, and wherein the first portion forms a frequency banded channel for a first range of frequencies, and wherein the second portion forms a frequency banded channel for a second range of frequencies, different from the first range of frequencies.

14. The integrated chiplet system of any one of claims 3 to 13,
wherein the directional coupler is a reconfigurable directional coupler; wherein the reconfigurable directional coupler can be configured to selectively direct more of an input signal to a first output than to a second output or to selectively direct more of the input signal to the second output than to the first output.

15. A method of directing a signal in an integrated chiplet system, the method comprising:

providing a waveguide that is configured to selectively direct a signal from a first antenna to a second antenna or a third antenna;
wherein the first antenna is configured to receive signals from, or send signal to, a printed circuit board (PCB), a second antenna, wherein the second antenna is configured to receive signals from, or send signals to, a first chiplet; and
a third antenna, wherein the third antenna is configured to receive signals from, or send signals to, a second chiplet;
preferably the method further comprising

a first chip package, comprising the first chiplet and the second antenna; and
a second chip package, comprising the second chiplet and the third antenna.

I/O

COMMS

NPU

102

CPU CORES

**FIG. 1**

FIG. 2

FIG. 3

**FIG. 4**

**FIG. 5**

**FIG. 6**

TTD-1

$\tau_1$

706

702

Coupler

704

Coupler

P#1 ○— Input    Through ○—

P#2

Input    Through ○— P#2

Coupled   Isolation ○ P#4    P#3 ○— Coupled   Isolation ○

TTD-2

$\tau_2$

708

**FIG. 7**

**FIG. 8**

**FIG. 9**

20

FIG. 10

1002
Gap
1004
1006

1102
V-Pol.
1112
1104
1106
1108
1110

FIG. 11A

1202
1204

FIG. 11B

1122
H-Pol.
1124

FIG. 12

FIG. 13

FIG. 14

FIG. 15

P#2

P#3

P#1

P#4

V-Pol

P#2

P#3

P#1

P#4

H-Pol

**FIG. 16**

V-Pol.

P#1

P#4

P#3

H-Pol.

P#1

P#4

P#3

dB

**FIG. 17**

**S-Parameters [Magnitude]**

S3,1_H-Pol.

S3,1_V-Pol.

dB

Frequency / GHz

**FIG. 18**

FIG. 19

FIG. 20

FIG. 21

FIG. 22

FIG. 23

FIG. 24

FIG. 25

FIG. 26

$b_S = b_{Tx}$   $a_1$   $T_1 = S_{21}$   $b_2$

Tx

$\Gamma_S$

$T_1$   $C_2 = S_{24}$   $\Gamma$

$b_1$   $C_2 = S_{13}$   $a_2$

$I_1 = S_{41}$   $I_1$   $I_2$   $I_2 = S_{23}$

$C_1 = S_{31}$

$a_4$   $C_1 = S_{42}$   $b_3$

$\Gamma_C$   $T_2$   $\Gamma_L$

Rx

$b_4$   $T_2 = S_{43}$   $a_3$

FIG. 27

## S-Parameters [Magnitude]

$$\Gamma_L = -\frac{I_1 + C_1 T_1 \Gamma}{C_1 T_2 + \left(T_1 T_2 + C_1^2 - I_1 I_2\right) I_2 \Gamma}$$

$$\Gamma_{L,Full} = -\frac{-I_1 \Gamma S_{33} + I_1 + C_1 T_1 \Gamma}{\left(I_1 S_{33} - C_1 T_2\right)\Gamma S_{33} - \left(I_1 + C_1 T_1 \Gamma\right) S_{33} + C_1 T_2 + \left(T_1 T_2 + C_1^2 - I_1 I_2\right)I_2 \Gamma}$$

Legend:
- ○ 50-Ohm Term
- ✳ Gamma_L
- ▲ Gamma_L, Approx
- ■ Gamma_L, Full

FIG. 28

FIG. 29

● : QPSK

● : 16-QAM

Q

I

FIG. 30

**FIG. 31**

**FIG. 32**

**FIG. 33**

Line

Ring

Ring + Star

Hub

Mesh

3402

Loops

3404

FIG. 34

$P_1$ All-Duplex Coupler $P_2$

$P_3$

$\triangleq$

Circulator

$P_1$ $P_2$

$P_3$

Programmable Control Signals

Circulator

Input

Terminated

Output 1
Output 2

Output N

Reconfigurable 1-to-N Power Splitter

FIG. 35

Programmable control
signals

Circulator                                    In/Out 1

Input 1                                                        Reconfigurable
                                                              channel
Throughput                                    In/Out N

                                                                              Drop 2

Reconfigurable-1-to-N
Power Splitter/Container

Programmable control
signals

Circulator                                    In/Out 1

Input 2

Drop 1                                        In/Out N

Reconfigurable-1-to-N
Power Splitter/Container

**FIG. 36**

**FIG. 37**

3802
**Port 1** O

Input $P_{in}$

**4-port
Directional
Coupler**

3804 O **Port 2**

Through $P_{thru}$

3806
**Port 3** O

Coupled $P_{cpl}$

3808 O **Port 4**

Isolated $P_{iso}$

**FIG. 38**

3802
**Port 1** O

Through $P_{thru}$

**4-port
Directional
Coupler**

3804 O **Port 2**

Input $P_{in}$

3806
**Port 3** O

Isolated $P_{iso}$

3808 O **Port 4**

Coupled $P_{cpl}$

**FIG. 39**

3802
**Port 1** O

Coupled $P_{cpl}$

**4-port
Directional
Coupler**

3804 O **Port 2**

Isolated $P_{iso}$

3806
**Port 3** O

Input $P_{in}$

3808 O **Port 4**

Through $P_{thru}$

**FIG. 40**

4102

**4-port
Directional
Coupler**

RX_A

TX_A

**C1 = 10 dB**

4104

**4-port
Directional
Coupler**

RX_B

TX_B

**C2 = 10 dB**

**FIG. 41**

**FIG. 42**

**FIG. 43**

**FIG. 44**

FIG. 45

FIG. 46

Controller
4770

FIG. 47

Europäisches
Patentamt
European
Patent Office
Office européen
des brevets

**EUROPEAN SEARCH REPORT**

Application Number

EP 25 16 9122

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/049883 A1 (MA YU GANG [SG] ET AL) 28 February 2013 (2013-02-28) | 1,2, 9-11,15 | INV. H01P5/04 |
| Y | * paragraphs [0008], [0026] - paragraph [0034]; figure 1 * | 3,7,8 | H01P5/18 |
| A | * paragraph [0038]; figure 4 * | 4-6, 12-14 | ADD. H01P3/16 |
| | ----- | | H01Q1/22 |
| Y | DING XUAN ET AL: "Design and Analysis of a Mode-Coupler-Based Multimode Multidrop Si Dielectric Waveguide Channel for Sub-THz/THz Interconnect", IEEE TRANSACTIONS ON MICROWAVE THEORY AND TECHNIQUES, IEEE, USA, vol. 72, no. 1, 1 January 2024 (2024-01-01), pages 111-123, XP011958167, ISSN: 0018-9480, DOI: 10.1109/TMTT.2023.3290189 [retrieved on 2023-07-11] * chapters I and III; figure 11 * * chapter II.B; figure 5 * | 3,7,8 | |
| | ----- | | |

**TECHNICAL FIELDS SEARCHED (IPC)**

H01P
H01Q

The present search report has been drawn up for all claims

| Place of search | Date of completion of the search | Examiner |
|---|---|---|
| The Hague | 10 September 2025 | Hueso González, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 16 9122

This annex lists the patent family members relating to the patent documents cited in the above-mentioned European search report.
The members are as contained in the European Patent Office EDP file on
The European Patent Office is in no way liable for these particulars which are merely given for the purpose of information.

10-09-2025

| Patent document cited in search report | Publication date | Patent family member(s) | Publication date |
|---|---|---|---|
| US 2013049883 A1 | 28-02-2013 | CN 102956945 A | 06-03-2013 |
| | | JP 2013046413 A | 04-03-2013 |
| | | SG 188009 A1 | 28-03-2013 |
| | | US 2013049883 A1 | 28-02-2013 |

EPO FORM P0459

For more details about this annex : see Official Journal of the European Patent Office, No. 12/82